(19) Europäisches Patentamt
European Patent Office
Office européen des brevets

(11) **EP 3 955 012 B1**

(12) **EUROPÄISCHE PATENTSCHRIFT**

(45) Veröffentlichungstag und Bekanntmachung des Hinweises auf die Patenterteilung:
**25.09.2024   Patentblatt 2024/39**

(21) Anmeldenummer: **20190886.0**

(22) Anmeldetag: **13.08.2020**

(51) Internationale Patentklassifikation (IPC):
**G01R 31/11** *(2006.01)*    **G01R 31/08** *(2020.01)*
**H02H 3/04** *(2006.01)*    **H02H 7/26** *(2006.01)*
**H02H 7/28** *(2006.01)*

(52) Gemeinsame Patentklassifikation (CPC):
**G01R 31/11; G01R 31/086; H02H 7/265;**
H02H 3/042; Y04S 10/52

(54) **VERFAHREN UND EINRICHTUNG ZUM ERMITTELN DES FEHLERORTES EINES FEHLERS AUF EINER LEITUNG EINES ELEKTRISCHEN ENERGIEVERSORGUNGSNETZES**

METHOD AND DEVICE FOR DETERMINING THE LOCATION OF A FAULT ON A LINE OF AN ELECTRICAL ENERGY SUPPLY NETWORK

PROCÉDÉ ET DISPOSITIF DE DÉTERMINATION DE L'EMPLACEMENT D'UN DÉFAUT SUR UNE CONDUITE D'UN RÉSEAU D'ALIMENTATION ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**16.02.2022   Patentblatt 2022/07**

(73) Patentinhaber: **Siemens Aktiengesellschaft**
**80333 München (DE)**

(72) Erfinder:
• **Dzienis, Cezary**
**14624 Dallgow-Döberitz (DE)**
• **Jurisch, Andreas**
**16727 Schwante (DE)**
• **Kogan, Igor**
**10719 Berlin (DE)**

(74) Vertreter: **Siemens Patent Attorneys**
**Postfach 22 16 34**
**80506 München (DE)**

(56) Entgegenhaltungen:
EP-A1- 3 660 523    WO-A1-2019/186490
WO-A1-2019/232595    CN-A- 106 019 077
CN-A- 109 034 467    US-A1- 2016 216 311

**Beschreibung**

Die Erfindung betrifft ein Verfahren zum Ermitteln des Fehlerortes eines Fehlers auf einer fehlerbehafteten Leitung eines elektrischen Energieversorgungsnetzes, das eine Mehrzahl von Leitungen, eine Mehrzahl von innenliegenden Knoten, die jeweils mindestens drei Leitungen miteinander verbinden, und mindestens drei außenliegende Knoten aufweist, wobei die außenliegenden Knoten jeweils eine Leitung begrenzen und mit Messeinrichtungen versehen sind, mit denen hochfrequente Strom- und oder Spannungssignale gemessen werden.

Die Erfindung betrifft auch eine Einrichtung zur Durchführung eines solchen Verfahrens.

Der sichere Betrieb elektrischer Energieversorgungsnetze erfordert eine schnelle und zuverlässige Erkennung und Abschaltung etwaiger Fehler, wie z.B. Kurzschlüsse oder Erdschlüsse. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Der Fehlerort, an dem sich der Fehler auf der Leitung befindet, kann mittels einer Analyse von während des Fehlereintritts erfassten Messgrößen, z.B. Strömen und Spannungen, eingegrenzt werden. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert daraufgelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Verfahren zur genaueren Fehlerortung verwenden beispielsweise die gemessenen Strom- bzw. Spannungssignale der Grundwelle (50Hz- bzw. 60Hz-Signale) zur Fehlerortung. Hierbei sind Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben. Im Fall der Verwendung von Messwerten nur eines Leitungsendes ist der Aufwand zur Durchführung der Fehlerortung gering. Bei dieser Fehlerortungsmethode handelt es sich überwiegend um eine impedanzbasierte Methode, bei der aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen. Eine beispielhafte Ausführung eines solchen Fehlerortungsverfahrens kann beispielsweise der US-Patentschrift US 4996624 A entnommen werden.

Eine verbesserte Genauigkeit bei der Fehlerortung lässt sich durch die Verwendung von Messwerten von beiden Leitungsenden erreichen. Hierbei müssen die fehlerortungsbezogenen Messwerte über eine geeignete Kommunikationsverbindung zusammengeführt werden. In diesem Zusammenhang sei auf die US-Patentschrift US 5,929,642 verwiesen; bei dem dort beschriebenen Verfahren wird unter Verwendung von Strom- und Spannungsmesswerten von beiden Leitungsenden mithilfe von Schätzverfahren und nichtlinearen Optimierungsverfahren eine recht hohe Genauigkeit (Messfehler ca. 1-2%) bei der Fehlerortung erreicht.

Während die Genauigkeit der Fehlerortung bei den impedanzbasierten Fehlerortungsverfahren von der Messgenauigkeit der verwendeten Messwandler sowie der Netzbeschaffenheit abhängt, lässt sich durch die Verwendung eines Fehlerortungsverfahrens nach dem sogenannten Wanderwellen-Prinzip ("Traveling Wave Fault Location") eine weitgehende Unabhängigkeit von diesen Größen erreichen. Nach diesem Prinzip werden anstelle der Grundwellen der gemessenen Strom- und Spannungssignale die beim Fehler entstehenden hochfrequenten Signalanteile, die in Form von sogenannten "Wanderwellen" auftreten, zur Fehlerortung in Betracht gezogen. Hierbei werden die hochfrequenten Wanderwellen-Flanken messtechnisch erfasst und mit einem Zeitstempel versehen. Da die Propagationsgeschwindigkeit der Wanderwellen etwa bei der Lichtgeschwindigkeit liegt, lässt sich aus der Auswertung der Zeitstempelung die Ortung des Fehlers gut durchführen. Mit diesem Fehlerortungsverfahren können Genauigkeiten im Bereich von wenigen Dutzend Metern erreicht werden. Ein Beispiel eines solchen Fehlerortungsverfahrens kann der US-Patentschrift US 8,655,609 B2 entnommen werden.

Ein anderes Verfahren zur Fehlerortung mit Wanderwellen, bei dem anstelle der Flanken eine Mustererkennung längerer zeitlicher Verläufe von Strom und/oder Spannung durchgeführt wird, ist zudem beispielsweise aus der Europäischen Patentanmeldung EP 3 193 420 A1 bekannt.

Die genannten Fehlerortungsverfahren eignen sich besonders für lineare Netztopologien ohne Verzweigungen, also für Leitungen mit zwei Leitungsenden. Eine schnelle Integration von regenerativen Energiequellen in sowie der Ausbau von bestehenden Energienetzen erfordern in vielen Situationen jedoch den Aufbau von Netztopologien, die von einem üblichen linearen Aufbau abweichen. Dabei werden häufig verzweigte Strukturen geschaffen, die als Zusammenfassung mehrerer Dreibein-Strukturen (oder T-Strukturen) mit mehr als zwei Leitungsenden (außenliegende Knoten) sowie mehreren innenliegenden Verzweigungspunkten (innenliegende Knoten) aufgefasst werden können. Diese erfreuen sich auch aus wirtschaftlichen Gründen großer Beliebtheit. Oftmals stellen solche Strukturen - auch im Vergleich mit der linearen Netztopologie - die einzige praktikable Alternative für einen erforderlichen Netzausbau dar. Somit steigt die Anzahl an Energieversorgungsnetzen, die zumindest teilweise die beschriebenen verzweigten Strukturen aufweisen.

Allerdings stellen solche verzweigten Strukturen der Netztopologie aus Sicht der Netzführung, der Netzüberwachung sowie des Netzschutzes eine große Herausforderung dar. Insbesondere kann es bei komplexen verzweigten Strukturen zu falschen Reaktionen von Schutzeinrichtungen kommen, so dass beispielsweise im Falle eines Netzfehlers eine korrekte Abschaltung des betroffenen Leitungsabschnitts nicht mehr gewährleistet werden kann. Schwierigkeiten bestehen außerdem auch bei der Ortung des Fehlers in solchen Netzstrukturen, so dass die Ergebnisse einer Fehlerortung oft unsicher sind, was bei der Wartung der Leitungen zu den erheblichen Aufwänden führt.

In einem verzweigten Energieversorgungsnetz innenliegende Knoten werden zudem üblicherweise nicht direkt messtechnisch überwacht. Gerade an solchen innenliegenden Knoten in Energieversorgungsnetzen ist es nämlich häufig nicht möglich, ein Fehlerortungsgerät einzubauen, da an den Verzweigungsmasten keine Möglichkeit für einen Geräteeinbau vorhanden ist (keine Wandler, keine Hilfsspannung, kein Platz zum Geräteeinbau). Für diese Einsatzfälle eignen sich also die bekannten Methoden zur zweiseitigen Fehlerortung nicht, da hier auch an dem innenliegenden Knoten der Einbau vor Geräten nötig wäre. Somit entsteht an einem solchen Knoten keine direkte Möglichkeit, auf den Status des Netzbetriebes zu schließen bzw. schutztechnisch zu reagieren.

Heutzutage erfolgt auch die Fehlerortung in verzweigten Netztopologien oft nach konventionellen Methoden. Überwiegend wird die zuvor beschriebene Methode der einseitigen Fehlerortung nach dem Impedanz-Prinzip eingesetzt. Da es sich um mindestens drei Leitungsenden handelt, werden drei Ergebnisse für den Fehlerort erzeugt. Nur eines der Ergebnisse kann jedoch richtig sein. Diese Vorgehensweise gibt keine Garantie, dass der korrekte Fehlerort gefunden wird. Auch eine zweiseitige Fehlerortung kann ein unsicheres Ergebnis liefern. Das hängt damit zusammen, dass die Abschaltung eines Fehlers nicht gleichzeitig in jedem Strang erfolgt und dadurch ein relativ stark transienter Zustand produziert wird. Demzufolge ist die genaue Ermittlung eines Zeigers als Grundlage für die Fehlerortung eine sehr große Herausforderung.

Aus der EP 3660523 A1 geht ein Verfahren zur Fehlerortung in einem verzweigten Energieversorgungsnetz mit mehr als zwei Enden hervor, bei dem zur Fehlerortung zunächst für jeden Knoten im Netz transiente Strom- und Spannungsverläufe berechnet werden. Mit diesen Informationen wird nachfolgend mittels eines Wanderwellen-Algorithmus der Fehlerort auf einer Leitung im Netz bestimmt. Auf diese Weise kann eine Fehlerortung mit hoher Genauigkeit auch in einem verzweigten Energieversorgungsnetz durchgeführt werden.

Die US 2016/216311 A1 beschreibt ein Verfahren zum Identifizieren eines fehlerhaften Gleichstrom-Leistungsübertragungsmediums in einem elektrischen Gleichstromnetz mit mehreren Anschlüssen.

Aus der CN 106019077 A geht ein Verfahren zur Optimierung der Platzierung von Wanderwellen-Fehlerortungsgeräten im Strommodus hervor.

Ein Beispiel für ein Mehrziel-Optimierungsverfahren eines katastrophenresistenten Backbone-Netzwerkrahmens eines Energiesystems wird in der CN 109034467 A erläutert.

Ein Verfahren und eine Vorrichtung zum Schutz eines Energieübertragungssystem mit mehreren Anschlüssen ist aus der WO 2019186490 A1 bekannt.

Die WO 2019232595 A1 beschreibt ein Verfahren zum Abschätzen des Ortes eines Fehlers in einem Elektrizitätsverteilungsnetz.

Der Erfindung die Aufgabe zugrunde, eine alternative Methode für eine Fehlerortung in einem verzweigten Energieversorgungsnetz anzugeben, die mit möglichst einfachen Mitteln durchgeführt werden kann.

Diese Aufgabe wird durch ein Verfahren der eingangs angegebenen Art gelöst, bei dem einer der außenliegenden Knoten als Startknoten für die Suche nach dem Fehlerort ausgewählt wird, ausgehend von dem Startknoten Pfade zu den anderen außenliegenden Knoten bestimmt werden, die mehrere Leitungen und innenliegende Knoten umfassen, und solche Pfade ausgewählt werden, auf denen der Fehlerort prinzipiell liegen könnte, für jeden der ausgewählten Pfade unter Verwendung der jeweiligen Zeitpunkte des Eintreffens der Wanderwellen eine Leitung ermittelt wird, auf der der Fehlerort prinzipiell liegen könnte, und für die jeweils ermittelte Leitung ein potentieller Fehlerort bestimmt wird.

Bei der hier vorgeschlagenen Vorgehensweise werden in vorteilhafter Weise Elemente der Graphentheorie mit der Fehlerortung verknüpft. Dazu werden ausgehend vom Startknoten Pfade durch das Energieversorgungsnetz gebildet und für jeden der Pfade eine Fehlerortung durchgeführt. Durch Anwendung der vorgeschlagenen Methode kann mit einfachen messtechnischen und kommunikationstechnischen Mitteln die Fehlerortung durchgeführt werden, da einerseits lediglich an den außenliegenden Knoten eine Erfassung und Zeitstempelung der Wanderwellen durchgeführt werden muss und andererseits lediglich die ermittelten Zeitpunkte - und damit eine kleine Datenmenge - zur Bestimmung des Fehlerortes an eine Einrichtung zur Fehlerortung übertragen werden müssen.

Die Wanderwellen-Fehlerortung lässt sich zudem prinzipiell durch viele Vorteile kennzeichnen. Einer der Vorteile ist der Wegfall der Notwendigkeit einer Zeigerberechnung für die Nominalfrequenz. Besonders bei sehr kurzen Abschaltzeiten eines Netzfehlers sind die zeigerbasierten Methoden bei der Ortung des Fehlers nicht immer verlässlich. Aus diesem Grund wird bei der vorliegenden Erfindung eine Wanderwellen-Fehlerortung angewendet. Diese benötigt lediglich eine Information über die Zeitpunkte, an denen die jeweilige Wanderwelle an den außenliegenden Knoten eingetroffen ist. Aufgrund der Geschwindigkeit des vorgeschlagenen Verfahrens kann dieses grundsätzlich auch zur Fehlererkennung und -abschaltung und nicht nur zur Fehlerortung eingesetzt werden.

Die Messeinrichtungen können die hochfrequenten Signale hierbei beispielsweise mit einer Abtastfrequenz oberhalb der Grundfrequenz der Signale, vorzugsweise mit einer Abtastrate zwischen 8kHz und 64kHz, erfassen. Auf diese Weise kann sichergestellt werden, dass die hochfrequenten transienten Signale korrekt erfasst und weiterverarbeitet werden können. Dabei sind höhere Abtastraten prinzipiell vorzuziehen.

Gemäß einer vorteilhaften Ausführungsform des erfindungsgemäßen Verfahrens ist vorgesehen, dass durch Vergleich der potentiellen Fehlerorte mindestens zweier ausgewählter Pfade der tatsächliche Fehlerort in dem Energieversorgungsnetz bestimmt wird.

Hierdurch wird eine Plausibilisierung durchgeführt, um das tatsächliche Ergebnis der Fehlerortung zu bestimmen. Dies kann insbesondere bei vermaschten Netzen erforderlich werden.

Eine weitere vorteilhafte Ausführungsform des erfindungsgemäßen Verfahrens sieht vor, dass als Startknoten derjenige außenliegende Knoten ausgewählt wird, an dem zuerst eine Wanderwelle detektiert worden ist.

Somit kann die Fehlerortung ausgehend von einem eindeutig definierten Startpunkt durchgeführt werden. Außerdem kann sichergestellt werden, dass der Fehlerort möglichst nah am Startknoten liegt.

Erfindungsgemäß ist vorgesehen, dass zur Ermittlung der Pfade das Energieversorgungsnetz auf mindestens eine Baumstruktur abgebildet wird.

Hierdurch kann eine einfach verarbeitbare Struktur geschaffen werden, in der nach der fehlerbehafteten Leitung gesucht werden kann. Dazu muss nur jeder Pfad der Baumstruktur bei der Fehlerortung abgearbeitet werden.

Konkret ist in diesem Zusammenhang vorgesehen, dass bei der Abbildung ein minimaler Baum mittels eines Kruska-Algorithmus ermittelt wird.

Der Kruska-Algorithmus ist ein aus der Graphentheorie bekannter Algorithmus zur Ermittlung desjenigen Baumes mit dem geringsten Pfadgewicht. Als Pfadgewicht kann vorliegend beispielsweise die Gesamtlänge der Leitungen eines Pfades oder die Laufzeit einer Wanderwelle über alle Leitungen des Pfades angesehen werden.

Konkret ist außerdem in diesem Zusammenhang vorgesehen, dass bei einem Energieversorgungsnetz mit mindestens einer Masche der minimale Baum und mindestens ein weiterer nicht-minimaler Baum ermittelt werden.

Als Masche wird hierbei eine Teilstruktur des Energieversorgungsnetzes angesehen, deren Start- und Endknoten identisch ist. Aufgrund von Vermaschungen lässt sich die verzweigte Struktur nicht vollständig in einem einzigen Baum abbilden, so dass pro Masche neben dem minimalen Baum ein weiterer (nicht minimaler) Baum erzeugt werden muss, um alle Leitungen bei der Fehlerortung zu berücksichtigen.

Eine weitere vorteilhafte Ausführungsform des erfindungsgemäßen Verfahrens sieht vor, dass zur Auswahl solcher Pfade, auf denen der Fehlerort prinzipiell liegen könnte, eine Zeitdifferenz der Zeitpunkte des Eintreffens der Wanderwellen an den außenliegenden Knoten des jeweiligen Pfades bestimmt wird, und solche Pfade ausgewählt werden, deren Zeitdifferenz kleiner ist als eine Gesamtlaufzeit einer Wanderwelle über den jeweiligen Pfad.

Auf diese Weise kann mit einer einfachen rechnerischen Betrachtung sichergestellt werden, dass nur solche Pfade bei der Fehlerortung berücksichtigt werden, auf denen der Fehler auch tatsächlich liegen kann. Liegt nämlich der Fehler irgendwo auf der Leitung, so kann die Zeitdifferenz maximal der Gesamtlaufzeit über den Pfad entsprechen. Dieser Extremfall liegt dann vor, wenn der Fehler in einem der außenliegenden Knoten aufgetreten ist. Ist folglich die Zeitdifferenz für einen betrachteten Pfad größer als die Gesamtlaufzeit einer Wanderwelle über diesen Pfad, so muss der Fehler zwangsläufig außerhalb dieses Pfades liegen.

Gemäß einer weiteren vorteilhaften Ausführungsform des erfindungsgemäßen Verfahrens kann zudem vorgesehen sein, dass - für jeden ausgewählten Pfad iterativ anhand einer virtuellen Zeitdifferenz geprüft wird, auf welcher Leitung des Pfades der Fehlerort liegen könnte, wobei zur Bildung der virtuellen Zeitdifferenz die Laufzeiten einer Wanderwelle von einem für die Iteration selektierten Knoten des Pfades zu einem jeweiligen außenliegenden Knoten des Pfades herangezogen werden.

Iterativ bedeutet in diesem Zusammenhang, dass ausgehend von dem Startknoten zunächst für eine erste Leitung des Pfades, die von dem Startknoten und dem nächsten innenliegenden Knoten begrenzt wird, geprüft wird, ob der Fehler auf dieser Leitung liegen könnte. Ist dies nicht der Fall, wird der betrachtete Bereich jeweils um die Leitung bis zum jeweils nächsten innenliegenden Knoten erweitert, bis schließlich der außenliegende Knoten des Pfades als Ende der Iteration erreicht ist.

In diesem Zusammenhang kann zur konkreten Bestimmung des Fehlerortes vorgesehen sein, dass - für eine Leitung, auf der der Fehlerort prinzipiell liegen könnte, anhand der Zeitpunkte, zu denen die Wanderwellen an den außenliegenden Knoten des betrachteten Pfades eingetroffen sind, und den Laufzeiten der Wanderwellen über nicht vom Fehler betroffene Leitungen des betrachteten Pfades der potentielle Fehlerort auf der Leitung bestimmt wird.

Auf diese Weise wird nach der Ermittlung, welche Leitung von dem Fehler betroffen ist, mittels eines durch die Laufzeiten der Wanderwellen über nicht fehlerbehaftete Leitungen korrigierten zweiseitigen Wanderwellen-Algorithmus der konkrete Fehlerort auf der Leitung bestimmt. Dazu müssen lediglich die Laufzeiten der Wanderwellen über die nicht fehlerbehafteten Leitungen berechnet werden.

Konkret kann zur Verifizierung des Fehlerortes vorgesehen sein, dass - als tatsächlicher Fehlerort derjenige Ort ausgewählt wird, auf den die meisten potentiellen Fehlerorte hinweisen. Somit kann auch bei abweichenden Ergebnissen für die potentiellen Fehlerorte ein tatsächlicher Fehlerort bestimmt werden.

Eine weitere vorteilhafte Ausführungsform des erfindungsgemäßen Verfahrens sieht vor, dass bei einem Energieversorgungsnetz mit mindestens einer Masche eine Baumstruktur des Energieversorgungsnetzes in zwei Teilbäume zerlegt wird, und die potentiellen Fehlerorte anhand der Zeitpunkte des Eintreffens der Wanderwellen an den außenliegenden Knoten der jeweiligen Teilbäume ermittelt werden.

Hierbei kann der Schnitt durch den Baum jeweils durch diejenige Leitung erfolgen, die als fehlerbehaftet angenommen wird.

Schließlich sieht eine weitere vorteilhafte Ausführungsform des erfindungsgemäßen Verfahrens vor, dass bei Kenntnis des tatsächlichen Fehlerortes eine Prüfung durchgeführt wird, ob es sich bei der fehlerbehafteten Leitung um eine Freileitung oder ein Erdkabel handelt, und bei einer Freileitung eine Wiedereinschaltautomatik eines die Leitung eines einen Fehlerstrom unterbrechenden Schalters freigegeben und bei einem Erdkabel die Wiedereinschaltautomatik blockiert wird.

Hierdurch kann die Schnelligkeit des vorgeschlagenen Verfahrens ausgenutzt werden, um neben der Fehlerortung auch schutzrelevante Funktionen, vorliegend die Freigabe oder Blockierung einer Wiedereinschaltautomatik, zu erfüllen. Da häufig Fehler auf Leitungen von kurzer Dauer sind, kann durch eine automatische Wiedereinschaltung der Leitung nach ihrer Abschaltung ein zeitnaher Weiterbetrieb des Energieversorgungsnetzes sichergestellt werden. Das automatische Verlöschen eines Fehlers findet jedoch nur auf Freileitungen statt, Erdkabel sind davon üblicherweise nicht betroffen. Daher muss vor einer automatischen Wiedereinschaltung eine Prüfung durchgeführt werden, ob der Fehler auf einer Freileitung oder auf einem Erdkabel liegt. Diese Information kann aus einer Topologiebeschreibung bei Kenntnis der fehlerbehafteten Leitung entnommen werden.

Die oben genannte Aufgabe wird auch durch eine Einrichtung zum Ermitteln des Fehlerortes eines Fehlers auf einer fehlerbehafteten Leitung eines elektrischen Energieversorgungsnetzes gelöst, das eine Mehrzahl von Leitungen, eine Mehrzahl von innenliegenden Knoten, die jeweils mindestens drei Leitungen miteinander verbinden, und mindestens drei außenliegende Knoten aufweist, wobei die außenliegenden Knoten jeweils eine Leitung begrenzen, wobei die Einrichtung eine Auswerteinrichtung aufweist, die dazu eingerichtet ist, nach dem Auftreten eines Fehlers auf der fehlerbehafteten Leitung jeweilige Zeitpunkte des Eintreffens von Wanderwellen an den außenliegenden Knoten zu detektieren und den Fehlerort unter Verwendung der detektierten Zeitpunkte zu ermitteln.

Erfindungsgemäß ist vorgesehen, dass die Auswerteinrichtung dazu eingerichtet ist, einen der außenliegenden Knoten als Startknoten für die Suche nach dem Fehlerort auszuwählen und ausgehend von dem Startknoten Pfade zu den anderen außenliegenden Knoten zu bestimmen, die mehrere Leitungen und innenliegende Knoten umfassen, und solche Pfade auszuwählen, auf denen der Fehlerort prinzipiell liegen könnte, die Auswerteinrichtung dazu eingerichtet ist, für jeden der ausgewählten Pfade unter Verwendung der jeweiligen Zeitpunkte des Eintreffens der Wanderwellen eine Leitung zu ermitteln, auf der der Fehlerort prinzipiell liegen könnte, und für die jeweils ermittelte Leitung einen potentiellen Fehlerort zu bestimmen, und die Auswerteinrichtung dazu eingerichtet ist, durch Vergleich der potentiellen Fehlerorte aller ausgewählten Pfade den tatsächlichen Fehlerort in dem Energieversorgungsnetz zu bestimmen.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Bezüglich der Einrichtung kann beispielsweise vorgesehen sein, dass die Einrichtung eine Messeinrichtung aufweist, mit der hochfrequente Strom- und/oder Spannungssignale an einem der außenliegenden Knoten gemessen werden.

In diesem Fall ist die Einrichtung an einem der außenliegenden Knoten vorgesehen und erhält von Messeinrichtungen an den anderen außenliegenden Knoten Informationen über die Zeitpunkte des Eintreffens der Wanderwelle an den anderen außenliegenden Knoten übermittelt. Es ist möglich, dass nur eine solche Einrichtung an dem Energieversorgungsnetz vorgesehen ist. Abweichend davon ist auch möglich, dass an mehreren oder allen außenliegenden Knoten eine solche Einrichtung vorgesehen ist. Solche Einrichtungen tauschen dann Informationen über die ermittelten Zeitpunkte untereinander aus und berechnen den Fehlerort in redundanter Weise.

Alternativ dazu kann auch vorgesehen sein, dass die Einrichtung eine separate Datenverarbeitungseinrichtung ist und dazu eingerichtet ist, hochfrequente Strom- und/oder Spannungssignale von externen Messeinrichtungen zu empfangen und jeweilige Zeitpunkte des Eintreffens von Wanderwellen an den außenliegenden Knoten zu bestimmen oder mittels der externen Messeinrichtungen selbst bestimmte jeweilige Zeitpunkte des Eintreffens von Wanderwellen an den außenliegenden Knoten zu bestimmen.

In diesem Fall sind die Messeinrichtungen zur Messung der hochfrequenten Signale und die Einrichtung zur Fehlerortung getrennte Geräte. Die Messeinrichtungen übermitteln die von ihnen bestimmten Zeitpunkte oder unmittelbar ihre erfassten Messwerte zur weiteren Auswertung an die separate Einrichtung.

Konkret kann in diesem Zusammenhang vorgesehen sein, dass die Einrichtung eine Cloud-Datenverarbeitungseinrichtung ist.

Dabei kann es sich um eine Plattform zur Anbietung von Cloudservices handeln, auf der eine Applikation ("App") zur Durchführung der Fehlerortung installiert ist. Bei der Plattform kann es sich beispielsweise um die Siemens Mindsphere© handeln.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen

Figur 1   eine schematische Ansicht eines verzweigten Energieversorgungsnetzes;

Figur 2   eine weitere schematische Ansicht eines verzweigten Energieversorgungsnetzes mit Maschen;

Figur 3   eine schematische Ansicht eines Leitungsabschnittes mit einer Einrichtung zur Ermittlung eines Fehlerortes;

Figur 4   das Energieversorgungsnetz aus Figur 1, bei dem auf einer Leitung ein Fehler aufgetreten ist;

Figur 5   beispielhafte Verläufe von hochfrequenten Stromsignalen an einem außenliegenden Knoten;

Figur 6   ein schematisches Ablaufschema zur Erläuterung der prinzipiellen Vorgehensweise bei einer Fehlerortbestimmung;

Figur 7   ein Beispiel einer Abbildung des Energieversorgungsnetzes aus Figur 1 auf eine Baumstruktur;

Figur 8   ein weiteres schematisches Ablaufschema zur Erläuterung der Vorgehensweise bei der Bestimmung eines potentiellen Fehlerortes auf einer Leitung;

Figuren 9-10  weitere (nicht minimale) Bäume als Abbildung des vermaschten Energieversorgungsnetzes aus Figur 2;

Figur 11   eine beispielhafte Aufteilung eines Baumes in zwei Teilbäume;

Figur 12   das Energieversorgungsnetz der Figur 1, bei dem Informationen zwischen den Messeinrichtungen übertragen werden; und

Figur 13   das Energieversorgungsnetz der Figur 1, bei dem Informationen von den Messeinrichtungen zu einer zentralen Datenverarbeitungseinrichtung übertragen werden.

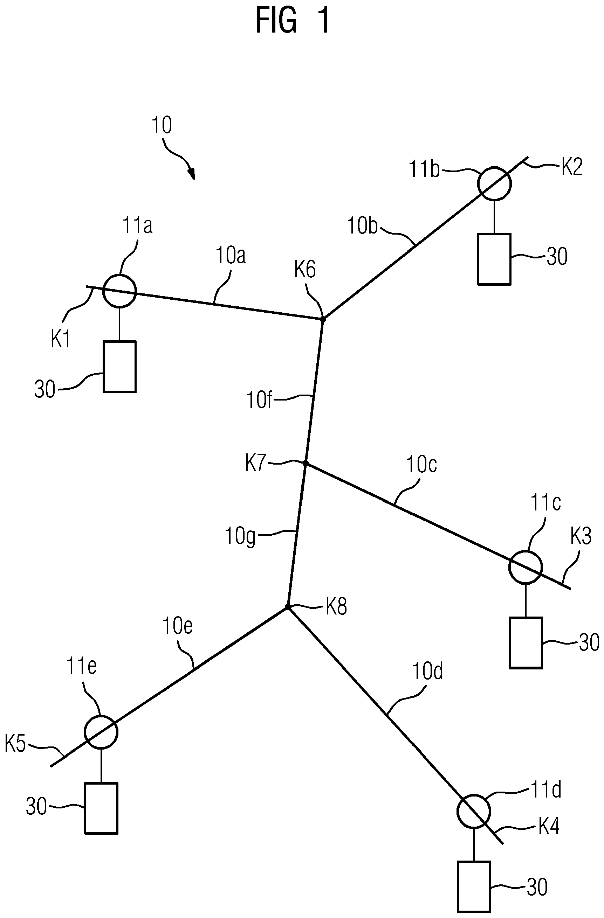

Figur 1 zeigt eine schematische Ansicht eines verzweigt aufgebauten elektrischen Energieversorgungsnetzes 10. Obwohl das Energieversorgungsnetz 10 in Figur 1 einphasig dargestellt ist, kann es auch mehrphasig, insbesondere dreiphasig, ausgebildet sein. Das Energieversorgungsnetz 10 umfasst mehrere Leitungen 10a-10g, außenliegenden Knoten K1-K5 sowie innenliegende Knoten K6-K8. Ein außenliegender Knoten K1-K5 begrenzt eine einzelne Leitung, während an einem innenliegenden Knoten K6-K8 mindestens drei Leitungen zusammentreffen. An den außenliegenden Knoten sind Messstellen 11a-11e vorgesehen, an denen mit geeigneten Sensoren Ströme und/oder Spannungen erfasst und an Messeinrichtungen 30 weitergeleitet werden. Die Messeinrichtungen 30 können hierbei separate Geräte sein, die dazu ausgebildet sind, hochfrequente Strom- und/oder Spannungssignale zu messen. Alternativ können die Messeinrichtungen auch Bestandteil von Einrichtungen zum Ermitteln eines Fehlerortes sein. Bei solchen Einrichtungen kann es sich zum Beispiel um IEDs (Intelligent Electronic Devices) in Form von elektrischen Schutzgeräten oder von Fehlerortern handeln.

Außerdem ist es möglich, dass die an den außenliegenden Knoten mit den Messeinrichtungen 30 aufgenommenen Ströme und/oder Spannungen bzw. davon abgeleitete Informationen zu einer zentralen Einrichtung zur Ermittlung des Fehlerortes weitergegeben werden. Dabei kann es sich um einen oder mehrere separate Recheneinrichtungen oder um eine Cloud-Plattform (z.B. die Mindsphere © Cloud der Siemens AG) handeln.

**EP 3 955 012 B1**

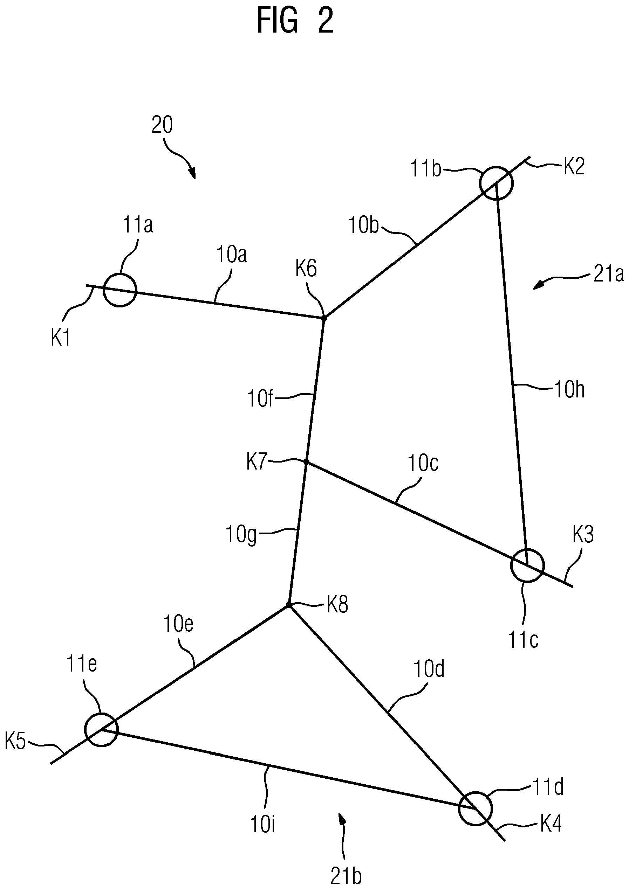

In Figur 2 ist eine Abwandlung des Energieversorgungsnetzes 10 aus Figur 1 gezeigt. Zusätzlich zu Verzweigungen weist das Energieversorgungsnetz 20 der Figur 2 auch Maschen 21a und 21b auf. Solche Vermaschungen können beispielsweise infolge bestimmter Schalterstellungen entstehen

Verzweigte und ggf. sogar vermaschte Netztopologien werden in letzter Zeit vermehrt eingesetzt, um beispielsweise auf Mittelspannungs- oder Niederspannungsebene dem Ausbau von Verteilnetzen zur Anbindung dezentraler Energieerzeuger (PV-Anlagen, Windräder, Blockheizkraftwerke etc.) zu begegnen. Während jedoch bei Leitungen mit zwei Leitungsenden eine Fehlererkennung und eine Fehlerortbestimmung unter Anwendung üblicher einseitiger oder zweiseitiger Fehlerortungsmethoden relativ einfach durchgeführt werden kann, ist die Erkennung und Ortung eines Fehlers in einer verzweigten Topologie mit größeren Schwierigkeiten verbunden. Nachfolgend wird ein Verfahren vorgestellt, mit dem auch in solchen verzweigten Netzstrukturen eine genaue Fehlerortbestimmung durchgeführt werden kann.

Hierzu macht sich die Erfindung das Konzept der Wanderwellen-Fehlerortung zunutze. Die Fehlerortbestimmung nach dem Prinzip der Wanderwellen betrachtet hochfrequente transiente Verläufe in den gemessenen Strömen und Spannungen nach dem Auftreten eines Fehlers im Energieversorgungsnetz. Von der Fehlerstelle breiten sich solche hochfrequenten Signalanteile wellenartig in alle Richtungen entlang der Leitungen des Energieversorgungsnetzes aus ("Wanderwellen"). Die Ausbreitung entlang der Leitung erfolgt mit einer bekannten Ausbreitungsgeschwindigkeit, so dass anhand des Eintreffens der Wanderwelle an den Leitungsenden auf den Fehlerort zurückgeschlossen werden kann. Die Wanderwellen-Fehlerortbestimmung besitzt mehrere Vorteile. Einer dieser Vorteile besteht darin, dass die Notwendigkeit der Zeigerberechnung für die Nominalfrequenz entfällt. Besonders bei sehr kurzen Abschaltzeiten eines Netzfehlers liefert die Transienten-Fehlerortung verlässlichere Ergebnisse als zeigerbasierte Methoden. Die Fehlerortbestimmung unter Verwendung von Wanderwellen liefert außerdem aufgrund der Analyse eines breiteren Frequenzspektrums ein zuverlässigeres Ergebnis. Besonders bei gelöscht oder isoliert betriebenen Netzen bietet diese Form der Fehlerortung eine hohe Zuverlässigkeit der ermittelten Ergebnisse.

Außerdem kann die Wanderwellen-Fehlerortung auch in vernetzten und vermaschten Topologien eingesetzt werden. In den in Figuren 1 und 2 gezeigten Beispielen wird angenommen, dass an den fünf außenliegenden Knoten K1-K5 Ströme und/oder Spannungen gemessen werden können. Für die Messung sind Messeinrichtungen zu verwenden, die eine Signalabtastung mit einer vergleichsweise hohen Abtastrate im Megahertzbereich vornehmen können. Der Grund dafür ist die Notwendigkeit der Aufzeichnung von Transienten, also hochfrequenten Signalanteilen, die mit herkömmlichen Messeinrichtungen mit vergleichsweise geringen Abtastraten nicht aufgenommen werden können. Die Erfassung kann beispielsweise mit einem Fault-Recorder oder einem Schutzgerät erfolgen. Bei den Beispielen der Figuren 1 und 2 wird zudem angenommen, dass an den drei innenliegenden Knoten K6-K8 keine Messeinrichtungen vorhanden sind, so dass dort keine Ströme und Spannungen messtechnisch erfasst werden können.

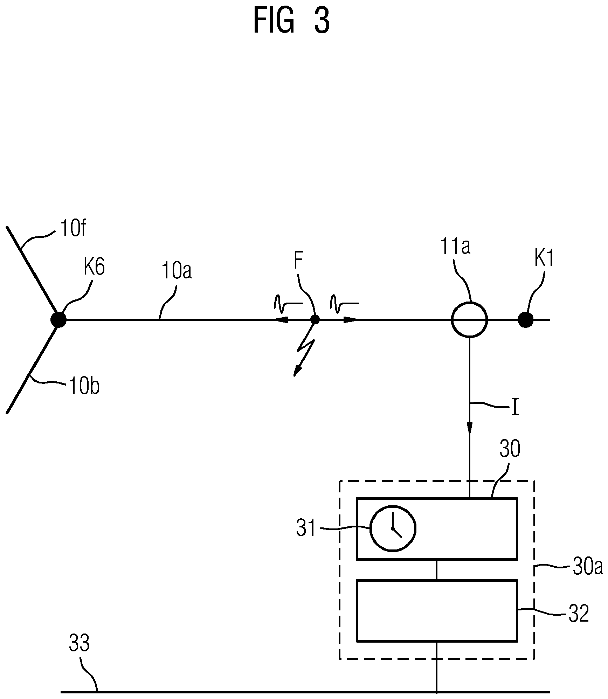

Figur 3 zeigt eine prinzipielle Anordnung zur Erfassung von Wanderwellen. Hierzu sei beispielhaft ein Fehler F auf der Leitung 10a zwischen dem außenliegenden Knoten K1 und dem innenliegenden Knoten K6 angenommen. Von der Fehlerstelle breiten sich hochfrequente transiente Signale in Form von Wanderwellen in beide Richtungen entlang der Leitung 10a aus. An der am außenliegenden Knoten K1 angeordneten Messstelle 11a werden die hochfrequenten Signale (in Figur 3 sind beispielhaft Stromsignale I dargestellt, es können aber alternativ oder zusätzlich aus Spannungssignale verwendet werden) mittels einer Messeinrichtung 30 erfasst und dort als Wanderwelle erkannt. Die Messeinrichtung arbeitet hierfür mit einer hohen Abtastrate im Megahertzbereich. Der Zeitpunkt des Eintreffens der ersten Flanke der Wanderwelle wird von der Messeinrichtung 30 mit einem hochgenauen Zeitgeber 31 erfasst und gespeichert.

Von der Fehlerstelle aus breitet sich die Wanderwelle zudem auch in Richtung des Knotens K6 und von dort aus über die Leitungen 10b und 10f weiter im Energieversorgungsnetz aus, bis sie an anderen außenliegenden Knoten messtechnisch erfasst wird.

Die Messeinrichtung 30 kann hierbei eine eigenständige Einrichtung sein. Wie in Figur 3 durch eine strichlierte Umrandung angegeben, kann die Messeinrichtung aber auch Bestandteil einer Einrichtung 30a zur Ermittlung des Fehlerortes sein, die eine Auswerteinrichtung 32 umfasst, mit der wie nachfolgend im Detail beschrieben anhand der Informationen über die Zeitpunkte des Eintreffens der Wanderwelle an allen außenliegenden Knoten des Energieversorgungsnetzes eine Fehlerortung durchgeführt wird. Hierzu ist die Einrichtung 30a mit einem Kommunikationsnetz 33 verbunden, über das die zur Fehlerortung benötigten Informationen von den anderen außenliegenden Knoten übermittelt werden.

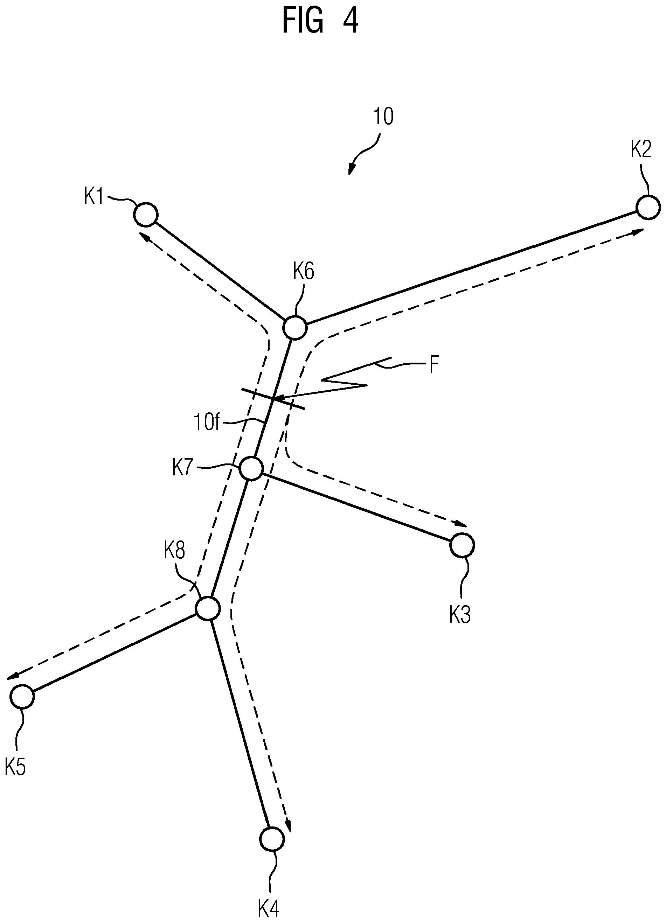

Figur 4 zeigt das Energieversorgungsnetz 10 der Figur 1, in dem ein Fehler F auf der Leitung 10f zwischen den innenliegenden Knoten K6 und K7 aufgetreten ist. Lediglich schematisch sind die Ausbreitungsrichtungen der an der Fehlerstelle entstehenden Wanderwellen mit gestrichelten Pfeilen angedeutet. An den außenliegenden Knoten K1 - K5 können diese Wanderwellen messtechnisch erfasst werden, die innenliegenden Knoten K6 - K8 weisen keine Messtechnik auf.

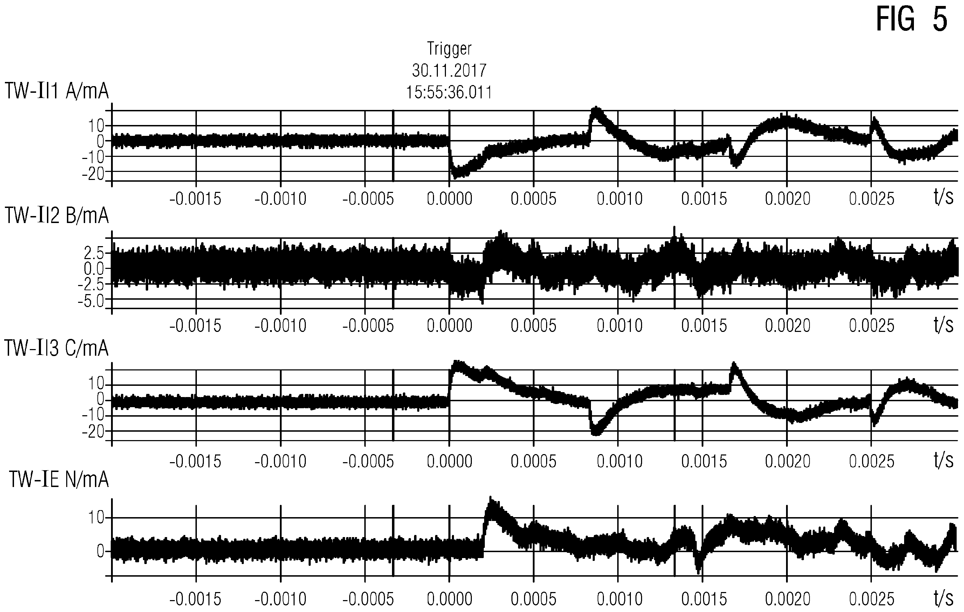

Figur 5 zeigt beispielhaft den Verlauf von (dreiphasigen) Stromsignalen beim Eintreffen der Wanderwelle am außenliegenden Knoten K1. Der beispielhaft dargestellte Verlauf wurde von einem zweipoligen Fehler mit Erdbeteiligung verursacht. Entsprechende Verläufe können an den anderen außenliegenden Knoten erfasst werden. Das Auftreten

7

der ersten Flanke der Wanderwelle triggert die Zuordnung eines Zeitpunktes des Eintreffens der jeweiligen Wanderwelle. Zu erkennen ist die sehr genaue zeitliche Auflösung der Daten. Der Trigger kommt mit einer Genauigkeit von wenigen Hundert Mikrosekunden. Die exakte Aufzeichnung der Zeit ist essenziell für den nachfolgend beschrieben Algorithmus. Um eine Fehlerortung durchführen zu können, müssen die Zeitpunkte des Eintreffens von Wanderwellen an den außenliegenden Knoten K1-K5 exakt erfasst und zu mindestens einer auswertenden Einrichtung übertragen werden. Die erfassten Zeitpunkte können auch einer zentralen Station übermittelt werden.

Die messtechnisch überwachten Knoten sind die Knoten K1-K5. Nach dem Auftreten eines Fehlers liefert jeder dieser Knoten eine eigenen Zeitpunkt der Erfassung der jeweiligen Wanderwelle; diese Zeitpunkte werden in Abhängigkeit der Nummerierung des jeweiligen Knotens mit $t_1$, $t_2$, $t_3$, $t_4$ und $t_5$ bezeichnet. Basierend auf diesen Zeitpunkte $t_1$-$t_5$ wird die Fehlerortung durchgeführt.

Ein Fehlerort $x_i$ als Entfernung vom Knoten i lässt sich mittels folgender grundlegenden Gleichung nach dem Wanderwellen-Prinzip für eine einfache Leitung mit zwei Enden bestimmen:

$$x_i = \frac{l_i + \Delta t_{ij} v}{2}$$

wobei $l_i$ die Leitungslänge zwischen Knoten i und j, $\Delta t_{ij}$ die gemessene Zeitdifferenz zwischen den ermittelten Zeitpunkten an den Knoten i und j sowie v Geschwindigkeit der Wanderwelle sind.

Bei einem verzweigten bzw. vermaschten Energieversorgungsnetz, wird die Lösung dieser Gleichung jedoch kein richtiges Ergebnis liefern, da hier keine eindeutige Leitung mit zwei Enden vorliegt und sich die Netztopologie dynamisch verändern kann. Das nachfolgend dargestellte Verfahren passt sich automatisch an die vorhandene Netztopologie an.

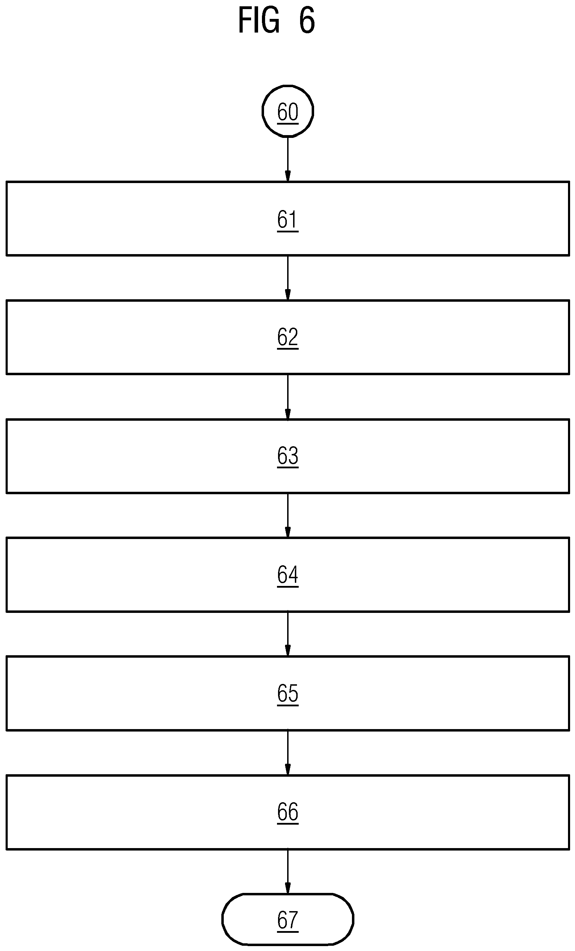

Die prinzipielle Vorgehensweise ist im Verfahrensablauf der Figur 6 dargestellt. In einem ersten Schritt 60 wird das Vorliegen eines Fehlers auf einer (unbekannten) der Leitungen 10a-g des Energieversorgungsnetzes 10 erkannt und die Suche nach dem Fehlerort ausgelöst. In einem folgenden Schritt 61 wird einer der außenliegenden Knoten K1-K5 als Startknoten für die Fehlerortsuche ausgewählt. Im folgenden Schritt 62 werden ausgehend von dem Startknoten Pfade zu den anderen außenliegenden Knoten durch das Energieversorgungsnetz gebildet. Im nachfolgenden Schritt 63 werden von den gebildeten Pfaden solche ausgewählt, auf denen der Fehler prinzipiell liegen könnte. Für jeden der in Schritt 63 ausgewählten Pfade wird in Schritt 64 mit einem iterativen Vorgehen eine Leitung ermittelt, auf der der Fehlerort liegen könnte und nachfolgend in Schritt 65 für die ausgewählte Leitung ein potentieller Fehlerort bestimmt. Dies erfolgt für alle ausgewählten Pfade, so dass nach Schritt 65 eine Mehrzahl potentieller Fehlerorte vorliegt. Schließlich wird in Schritt 66 durch Vergleich der potentiellen Fehlerorte der tatsächliche Fehlerort ermittelt und in Schritt 67 ausgegeben.

Nachfolgend werden die einzelnen Schritte im Detail erläutert.

In Schritt 60 wird kontinuierlich überwacht, ob ein Fehler im Energieversorgungsnetz 10 aufgetreten ist. Eine solche Erkennung kann unter Verwendung allgemein bekannter Schutzalgorithmen erfolgen, die auf Basis von an den außenliegenden Knoten K1-K5 erfassten Messwerten eine Entscheidung darüber treffen, ob sich eine Leitung des Energieversorgungsnetzes 10 in einem fehlerbehafteten Zustand befindet. Beispielsweise kann hierfür ein Distanzschutzalgorithmus, ein Differentialschutzalgorithmus, ein Überstromschutz-Algorithmus oder ein anderer Schutzalgorithmus eingesetzt werden. Sofern in Schritt 60 kein Fehler erkannt worden ist, wird die kontinuierliche Überwachung fortgesetzt. Sofern hingegen ein Fehler erkannt worden ist, werden Ströme und/oder Spannungen an allen außenliegenden Knoten K1-K5 durch hochfrequente Abtastung erfasst und auf das Eintreffen von Wanderwellen untersucht. Die Zeitpunkte des Eintreffens der Wanderwellen werden festgehalten. Als Ergebnis des Schrittes 60 liegt für jeden außenliegenden Knoten K1-K5 ein Zeitpunkt vor, der das Eintreffen der jeweiligen Wanderwelle an dem betreffenden Knoten angibt.

In Schritt 61 wird als Startknoten für die Suche nach dem Fehlerort derjenige Knoten festgelegt, an dem die entsprechende Wanderwelle zuerst eingetroffen ist, der also den frühesten Zeitpunkt aufweist. Dieser Knoten liegt am nächsten an dem gesuchten Fehlerort. Im vorliegenden Beispiel wird der außenliegende Knoten K1 als Startknoten ausgewählt.

In Schritt 62 werden ausgehend von dem Startknoten Pfade zu den anderen außenliegenden Knoten durch das Energieversorgungsnetz gebildet. Dazu findet vorteilhaft eine Abbildung der Topologie des Energieversorgungsnetzes auf eine Baumstruktur statt.

Für diese Abbildung der Netztopologie werden Kenntnisse aus der Graph-Theorie eingesetzt. Dabei werden folgende Definitionen genutzt:

- ein Netzgraph ist eine Abbildung eines Netzes, dem N Knoten K und $l_i$ Leitungen (Zweige) zugeordnet werden;
- eine Leitung $l_i$ (Zweig) verbindet zwei Knoten $K_i$ und $K_j$ miteinander;

- ein Pfad ist eine Sammlung von Leitungen $l_i$, die zwei außenliegende Knoten miteinander verbinden, wobei jeder Knoten des Pfades nur einmal auftritt;
- eine Masche ist eine Verbindung von Leitungen $l_i$, in der derselbe Knoten den Anfang und das Ende bildet;
- ein Baum ist ein Untergraph eines Netzes, in dem alle Knoten vorhanden sind und keine Maschen entstehen.

Da zunächst unbekannt ist, auf welcher Leitung der Fehler liegt, muss mit der Erstellung eines sogenannten Netzbaums (kurz "Baum") begonnen werden. Bei vermaschten Systemen (vgl. Figur 2) lassen sich mehrere Bäume erstellen, um bei der Fehlerortung alle Leitungen berücksichtigen zu können. Diese Variante wird später erläutert. Vorliegend soll das verzweigte Netz aus Figur 1 als Beispiel betrachtet werden.

In einer ersten Phase des Schrittes 62 wird zunächst der sogenannte "minimale Baum" als Abbildung des Energieversorgungsnetzes erstellt. Der minimale Baum verbindet alle Knoten miteinander und weist insgesamt die kleinste Zweiggewichtung auf. Als Zweiggewichtung kann entweder eine Leitungslänge oder eine Laufzeit der Wanderwelle durch den jeweiligen Zweig angesehen werden. Die Suche nach dem minimalen Baum erfolgt vorteilhaft unter Verwendung des Kruskal-Algorithmus. Beginnend mit der kleinsten Zweiggewichtung wird hierbei der Baum Schritt für Schritt um den Zweig mit der jeweils nächstkleinsten Zweiggewichtung aufgebaut. Die Suche nach geeigneten Zweigen erfolgt vorteilhaft von denjenigen Knoten aus, die bereits in den Baum integriert worden sind. Die Integration erfolgt automatisch durch das Einfügen der neuen Zweige. Solche Zweige, durch die eine Masche gebildet werden würde, werden bei der Suche nach geeigneten Zweigen verworfen.

Nach Erzeugen des Baumes werden in einer weiteren Phase des Schrittes 62 die Pfade vom Startknoten K1 zu den anderen außenliegenden Knoten K2-K5 gebildet.

Zur Durchführung der Pfadbestimmung wird vorteilhafterweise eine Rekursion eingesetzt, bei der ausgehend vom Startknoten mittels Verfolgung der daran angeschlossenen Leitungen der jeweils nächste Knoten im Pfad ermittelt wird. Bei der Bestimmung der Pfade werden folgende Abbruchbedingungen verwendet:

- der gefundene nächste Knoten ist ein außenliegender Knoten;
- der gefundene nächste Knoten ist bereits im Pfad enthalten.

In diesem Fall wird der komplette Pfad verworfen (eine Masche wurde gefunden).

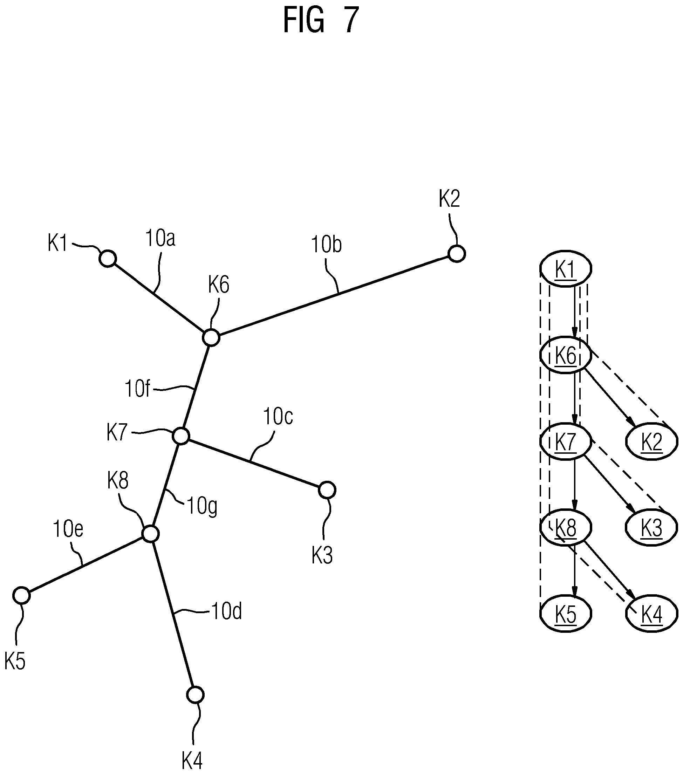

Im vorliegenden Beispiel läuft die Vorgehensweise zur Bestimmung der Pfade wie nachfolgend beschrieben ab. Die schrittweise Ermittlung der Pfade ist auf der rechten Seite in Figur 7 angedeutet.

a) Start beim Startknoten K1 (Annahme: K1 ist der Knoten mit der kleinsten Absolutzeit der erkannten Wellenfront) ;
b) Einfügen Leitung 10a von Knoten K1 zum Knoten K6;
c) Einfügen Leitung 10b von Knoten K6 zum Knoten K2;
d) Abbruch für den ersten Pfad K1-K6-K2 erreicht, da K2 ein außenliegender Knoten ist;
e) Einfügen Leitung 10f von Knoten K6 zum Knoten K7;
f) Einfügen Leitung 10c von Knoten K7 zum Knoten K3;
g) Abbruch für den zweiten Pfad K1-K6-K7-K3 erreicht, da K3 ein außenliegender Knoten ist;
h) Einfügen Leitung 10g von Knoten K7 zum Knoten K8;
i) Einfügen Leitung 10e von Knoten K8 zum Knoten K5;
j) Abbruch für den dritten Pfad K1-K6-K7-K8-K5 erreicht, da K5 ein außenliegender Knoten ist;
k) Einfügen Leitung 10d von Knoten K8 zum Knoten K4;
l) Abbruch für den vierten Pfad K1-K6-K7-K8-K4, da K4 ein außenliegender Knoten ist;
m) Abbruch der Ermittlung von Pfaden, da keine weiteren Pfade zu verfolgen sind.

Nach Schritt 62 liegt somit eine vollständige Sammlung von Pfaden vor, die den Startknoten mit anderen außenliegenden Knoten verbinden.

In Schritt 63 werden aus den Pfaden solche ausgewählt, auf denen der Fehlerort liegen könnte. Dabei werden nur solche Pfade berücksichtigt, für die an beiden außenliegenden Knoten eine Wanderwelle erkannt wurde und bei denen die Zeitdifferenz zwischen den Zeitpunkten des Eintreffens der jeweiligen Wanderwelle kleiner oder gleich der Gesamtlaufzeit einer Wanderwelle über den jeweiligen gesamten Pfad beträgt.

Für jeden gefundenen Pfad wird somit die Gesamtlaufzeit einer Wanderwelle über den Pfad unter Verwendung der bekannten Leitungslängen $l_i$ und den Ausbreitungsgeschwindigkeiten $v_i$ auf der jeweiligen Leitung $l_i$ berechnet. Aufgrund unterschiedlicher Leitungsparameter (z.B. aufgrund der Ausbildung als Freileitung oder Erdkabel) können die Ausbreitungsgeschwindigkeiten $v_i$ zwischen den einzelnen Leitungen $l_i$ differieren. Die Gesamtlaufzeit $t_{Pfad(Kn-Km)}$ für einen Pfad zwischen den Knoten Kn (Startknoten) und Km (jeweiliger außenliegender Knoten) berechnet sich wie folgt:

$$t_{Pfad(Kn-Km)} = \sum_{i=1}^{N} \frac{l_i}{v_i}$$

Hierbei steht N für die Anzahl der Leitungen auf dem betrachteten Pfad zwischen den Knoten Kn und Km, $l_i$ für die Länge der i-ten Leitung im Pfad und $v_i$ für die Wellenausbreitungsgeschwindigkeit auf der i-ten Leitung im Pfad.

Weiterhin wird für jeden Pfad die Differenzzeit $\Delta t_{Pfad}$ der Zeitpunkte des Eintreffens der Wanderwellen zwischen den Knoten Kn und Km am Anfang und am Ende des Pfades gebildet. Diese Zeitdifferenz lässt sich aus den Zeitpunkten $t_{Kn}$ und $t_{Km}$ ermitteln, die an den Knoten Kn und Km erfasst worden sind.

$$\Delta t_{Pfad} = t_{Kn} - t_{Km}$$

Zur Bestimmung, ob der Fehler überhaupt auf dem betrachteten Pfad liegen kann, muss folglich die nachfolgende Bedingung geprüft werden:

$$\Delta t_{Pfad} \leq t_{Pfad(Kn-Km)} \cdot$$

Ist diese Bedingung erfüllt, könnte der Fehler auf dem Pfad liegen und der Pfad wird entsprechend als potentiell fehlerhafter Pfad ausgewählt. Der beschriebene Algorithmus wird für alle in Schritt 62 gefundenen Pfade getrennt ausgeführt. Auf diese Weise kann im vorliegenden Beispiel der Pfad K1-K6-K2 ausgeschlossen werden, da der Fehler nicht auf diesem Pfad liegen kann.

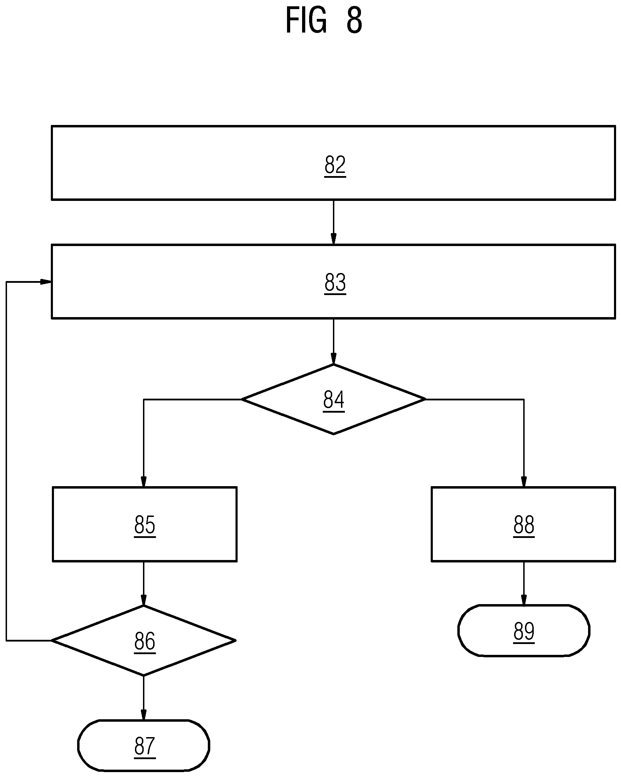

In Schritt 64 wird in einem iterativen Vorgehen für die ausgewählten Pfade die jeweilige Leitung ermittelt, auf der der Fehler liegen könnte. Diese Vorgehensweise wird unter Zuhilfenahme von Figur 8 eingehender erläutert.

Die Abarbeitung beginnt mit Schritt 82 mit der Bereitstellung der möglicherweise von dem Fehler betroffenen Pfade entsprechend der oben zu Schritt 63 erläuterten Vorgehensweise.

In Schritt 83 beginnt eine Iteration, bei der zunächst eine virtuelle Zeitdifferenz $\Delta t_{Pfad,Kp}$ für den jeweils nächsten auf dem Pfad liegenden Knoten Kp bestimmt wird. In Schritt 84 wird geprüft, ob die für den betrachteten Pfad ermittelte Zeitdifferenz $\Delta t_{Pfad}$ größer oder gleich dieser virtuellen Zeitdifferenz ist:

$$\Delta t_{Pfad} \geq \Delta t_{Pfad,Kp}$$

Hierbei bestimmt sich die virtuelle Zeitdifferenz als Differenz aus den Zeitpunkten, zu denen die jeweilige Wanderwelle an dem jeweils betrachteten Knoten Kp einmal ausgehend vom Startknoten Kn und einmal ausgehend vom Endknoten (dem anderen außenliegenden Knoten) Km eingetroffen ist:

$$\Delta t_{Pfad,Kp} = t_{Kp-Kn} - t_{Kp-Km}$$

Während am Startknoten und am Endknoten der Zeitpunkt des Eintreffens der Wanderwelle messtechnisch erfasst worden und damit bekannt ist, ist dieser für den nächsten Knoten Kp hingegen üblicherweise nicht bekannt und muss rechnerisch bestimmt werden. Der Zeitpunkt ergibt sich aus dem jeweiligen durch Messung bekannten Zeitpunkt $t_{Kn}$ (Startknoten) und $t_{Km}$ am Endknoten (am entfernten außenliegenden Knoten) des Pfades unter Berücksichtigung der zwischen diesen und dem betrachteten Knoten $K_p$ liegenden Leitungen und der jeweiligen Ausbreitungsgeschwindigkeit:

$$t_{Kp-Kn} = t_{Kn} - \sum_{i=1}^{Nn} \frac{l_i}{v_i}$$

$$t_{Kp-Km} = t_{Km} - \sum_{i=1}^{Nm} \frac{l_i}{v_i}$$

wobei Nn die Anzahl der zwischen dem Startknoten Kn und dem betrachteten Knoten Kp liegenden Leitungen und Nm die Anzahl der zwischen dem Endknoten und dem betrachteten Knoten liegenden Leitungen ist.

Wird bei Schritt 84 festgestellt, dass die oben genannte Bedingung nicht erfüllt ist, so wird das Verfahren bei Schritt 88 fortgesetzt, in dem die aktuell betrachtete Leitung als möglicherweise fehlerbehaftet erkannt und ein potentieller Fehlerort auf der Leitung berechnet wird. Die Information über den potentiellen Fehlerort wird in Schritt 89 bereitgestellt.

Ist die oben genannte Bedingung hingegen erfüllt, dann liegt der Fehlerort auf dem betrachteten Knoten Kp oder außerhalb der aktuell untersuchten Leitung des Pfades. Das Verfahren wird mit Schritt 85 fortgesetzt, in dem der betrachtete Teil des Pfades um die Leitung bis zum nächsten Knoten verlängert wird. Wird dieser nächste Knoten in Schritt 86 bereits als Endknoten des Pfades (der außenliegende Knoten) erkannt, dann wird das Verfahren mit Schritt 87 beendet. Der Fehler muss dann auf der zuletzt hinzugenommenen Leitung liegen. Ist der nächste Knoten hingegen nicht der Endknoten des Pfades (ein weiterer innenliegender Knoten), so wird ein neuer Durchlauf der Iteration bei Schritt 83 gestartet und es wird nunmehr eine virtuelle Zeitdifferenz $\Delta t_{Pfad,Kp}$ einer Wanderwelle für den zuletzt hinzugenommenen Knoten Kp berechnet. In Schritt 84 wird daraufhin geprüft, ob die Zeitdifferenz $\Delta t_{Pfad}$ größer oder gleich dieser virtuellen Zeitdifferenz $\Delta t_{Pfad,Kp}$ ist.

Im vorliegenden Beispiel ist für einen betrachteten Pfad K1-K6-K7-K3 im ersten Durchgang des Schrittes 83 der innenliegende Knoten K6 ausgehend von dem Startknoten K1 der nächste auf dem Pfad liegende Knoten Kp. Somit ist zu überprüfen, ob die Zeitdifferenz $\Delta t_{Pfad}$ für den gesamten Pfad größer oder gleich der virtuellen Zeitdifferenz $\Delta t_{Pfad,K6}$ für den Knoten K6 ist:

$$\Delta t_{Pfad} \geq \Delta t_{Pfad,K6}$$

mit

$$\Delta t_{Pfad,K6} = t_{K6-K1} - t_{K6-K3}$$

Hierbei gelten

$$t_{K6-K1} = t_{K1} - \sum_{i=1}^{1} \frac{l_i}{v_i} = \frac{l_1}{v_1}$$

wobei die in diesem Zusammenhang betrachtete Leitung 1 ausgehend von Knoten K1 in Figur 1 das Bezugszeichen 10a trägt, und

$$t_{K6-K3} = t_{K3} - \sum_{i=1}^{2} \frac{l_i}{v_i} = \frac{l_1}{v_1} + \frac{l_2}{v_2}$$

wobei die in diesem Zusammenhang betrachtete Leitung 1 ausgehend von Knoten K3 in Figur 1 das Bezugszeichen 10c und die in diesem Zusammenhang betrachtete Leitung 2 ausgehend von Knoten K3 in Figur 1 das Bezugszeichen 10f trägt.

Im vorliegenden Beispiel ergibt sich durch Abprüfen der obigen Bedingung, dass der Fehler nicht auf der ersten Leitung 10a liegt. Daher wird in der nächsten Iteration der nächste Knoten auf dem Pfad ausgewählt. Im vorliegenden Beispiel handelt es sich um den Knoten K7. Da für diesen die Bedingung

$$\Delta t_{Pfad} \geq \Delta t_{Pfad,K7}$$

nicht erfüllt ist, muss der Fehler auf der zuletzt hinzugenommen Leitung 10f zwischen den Knoten K6 und K7 liegen. Wäre dies nicht der Fall, müsste die Iteration entsprechend fortgesetzt werden, bis das Ende des Pfades erreicht ist.

Zur Bestimmung des potentiellen Fehlerortes auf der in Schritt 88 ausgewählten Leitung (vgl. auch Schritt 65 in Figur 6) werden zunächst die Laufzeiten einer Wanderwelle auf den nicht von dem Fehler betroffenen Leitungen des Pfades bestimmt:

$$t_{Kp-Kn} = \sum_{i=1}^{Nn} \frac{l_i}{v_i}$$

$$t_{K(p+1)-Km} = \sum_{i=1}^{Nm} \frac{l_i}{v_i}$$

Die fehlerbehaftete Leitung befinde sich zwischen Knoten Kp und K(p+1). Die Laufzeiten werden für den Anfangsknoten von Kn bis zum ersten die fehlerbehaftete Leitung begrenzenden Knoten Kp sowie für den Endkonten Km bis zum zweiten die fehlerbehaftete Leitung begrenzenden Knoten K(p+1) berechnet.

Für die gefundene fehlerbehaftete Leitung wird nun die Bestimmung eines potentiellen Fehlerortes unter Anwendung der folgenden Gleichung durchgeführt:

$$x_i = \frac{l_i + \left( \Delta t_{Pfad} - (t_{Kp-Kn} - t_{K(p+1)-Km}) \right) \cdot v_i}{2}$$

Im vorliegenden Beispiel liegt der Fehler zwischen den Knoten K6 und K7. Damit ergibt sich der potentielle Fehlerort entsprechend der Gleichung

$$x_2 = \frac{l_2 + \left( \Delta t_{Pfad} - (t_{K6-K1} - t_{K7-K3}) \right) \cdot v_2}{2}$$

Im hier vorliegenden Beispielfall handelt sich um die Leitung 2 (Bezugszeichen 10f) mit der Länge $l_2$ auf dem Pfad K1-K6-K7-K3.

Die beschriebene Vorgehensweise wird für mindestens einen der ausgewählten Pfade durchgeführt. Durch Vergleich der Ergebnisse mehrerer Pfade lässt sich das Ergebnis verifizieren. In diesem Fall wird derjenige potentielle Fehlerort als tatsächlicher Fehlerort bestimmt, auf den die meisten der ermittelten potentiellen Fehlerorte hinweisen.

Da im Energieversorgungsnetz auch Leitungen existieren können, die im aktuellen Pfad nicht enthalten sind, muss sich die fehlerbehaftete Leitung nicht notwendigerweise auf dem aktuellen Pfad befinden. In diesem Fall wird für den aktuellen Pfad als Fehlerort derjenige Knoten mit dem Abgang zur fehlerbehafteten Leitung berechnet. Liegt der bestimmte potentielle Fehlerort also im Bereich der Messfehler direkt an einem der Knoten, dann muss der Fehlerort auf jeden Fall über einen weiteren Pfad verifiziert werden. Liefern alle Pfade, die den als potentiellen Fehlerort bestimmten Knoten enthalten, diesen Netzknoten als Fehlerort, dann ist der Netzknoten der tatsächliche Fehlerort. Andernfalls ist als Fehlerort der Fehlerort des Pfades zu verwenden, der einen Fehlerort auf einer Leitung bestimmt hat. Wird also ein potentieller Fehlerort auf einer Leitung und ein oder mehrere potentielle Fehlerorte am Knoten mit dem Abgang zu dieser Leitung ermittelt, so weisen die bestimmten potentiellen Fehlerorte somit auf den auf der Leitung liegenden Fehlerort hin.

Wie beschrieben wird der Baum der Wellenausbreitungspfade immer ausgehen vom Knoten mit der geringsten erkannten Absolutzeit des Eintreffens der Wanderwelle (Startknoten) geprüft. Damit ist sichergestellt, dass dieser Knoten der Fehlerstelle am nächsten liegt und mindestens ein von diesem Knoten ausgehender Pfad die Fehlerstelle enthält.

Für den Fall einer starken Vermaschung des Energieversorgungsnetzes (vgl. Figur 2) muss die Netzstruktur neben dem minimalen Baum auch auf weitere (nicht minimale) Bäume abgebildet werden, um jede Möglichkeit einer fehlerbehafteten Leitung berücksichtigen zu können. Bei einem Vergleich zwischen dem minimalen Baum der Figur 7 und der Netzstruktur der Figur 2 lässt sich nämlich einfach feststellen, dass nicht alle Leitungen (Zweige) von dem minimalen Baum berücksichtigt werden. Es fehlen Leitungen 10h und 10i.

Aus diesem Grund müssen weitere Bäume erzeugt werden, die die im minimalen Baum fehlenden Leitungen berücksichtigen. Die Erstellung der weiteren Bäume erfolgt ebenfalls nach dem Kruskal-Algorithmus mit dem Unterschied, dass als Startzweig einer der nicht im minimalen Baum bereits berücksichtigten Zweige gewählt wird.

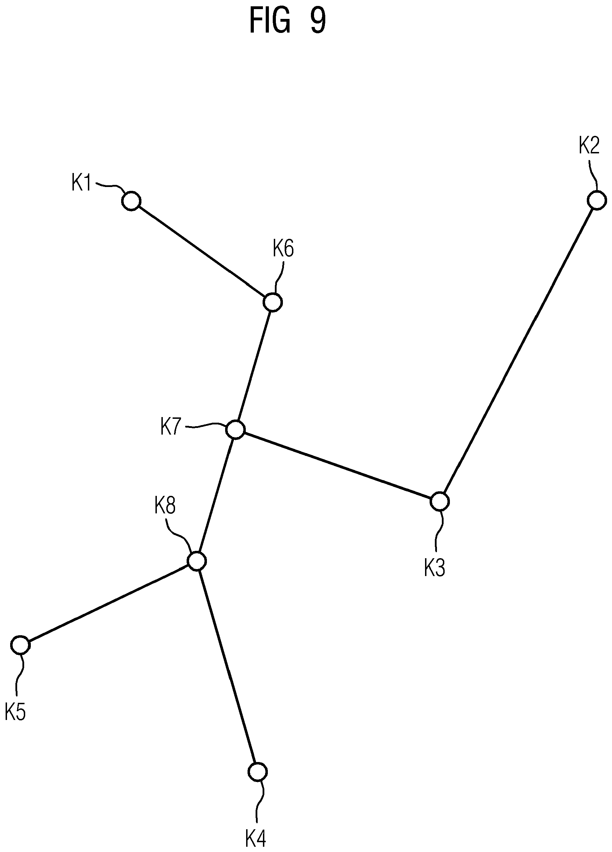

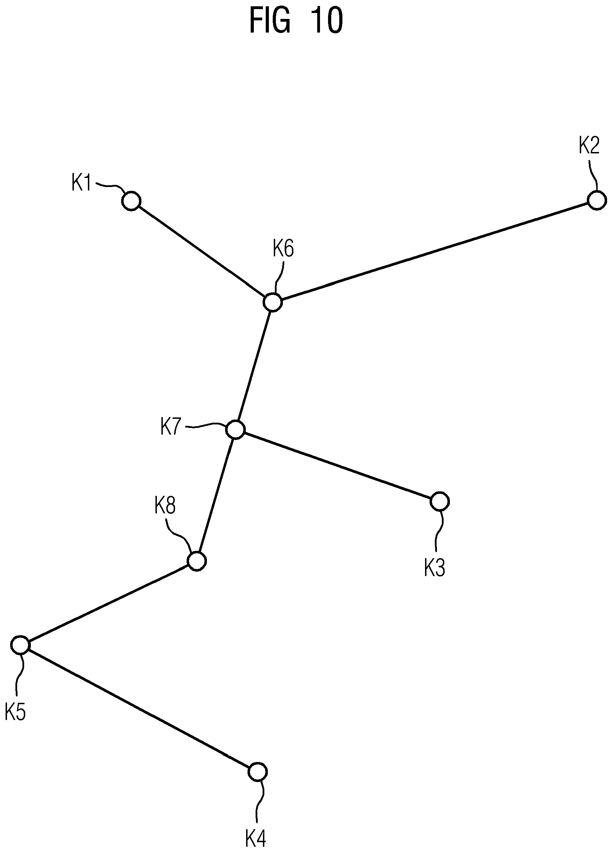

Im beispielhaften Fall der Figur 2 werden somit zwei weitere Bäume gebildet, die in Figuren 9 und 10 gezeigt sind, so dass als Grundlage für die Fehlerortung drei Bäume (der minimale Baum gemäß Figur 7 sowie die nicht minimalen Bäume der Figuren 9 und 10) vorliegen.

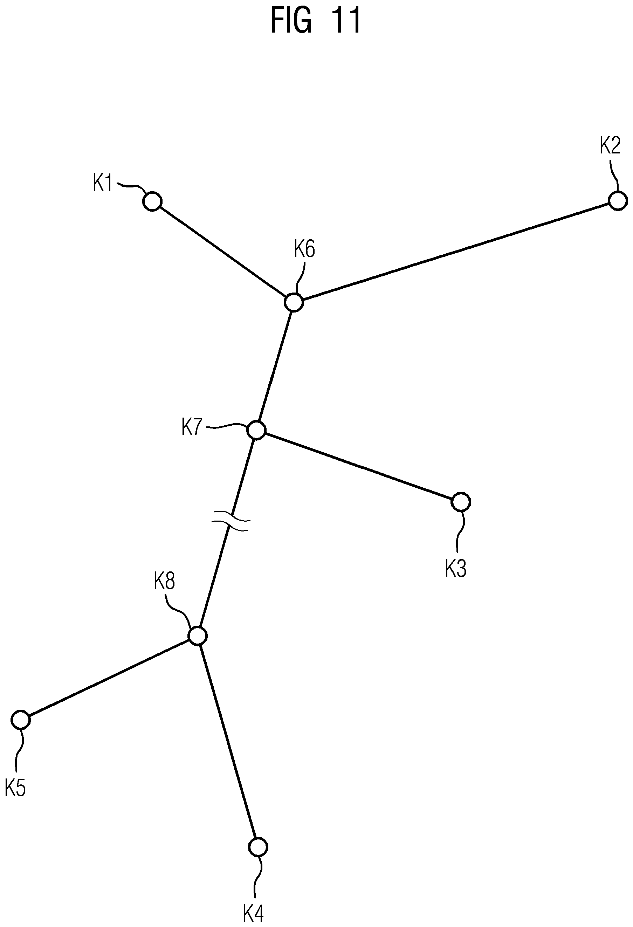

Der Aufbau aller Baumstrukturen ist bei vermaschten Netzen notwendig für die flexible Suche des Fehlerortes. Da die fehlerbehaftete Leitung nicht bekannt ist, muss jede Leitung auf den potentiellen Fehlerort untersucht werden. Um dies zu unterstützen, kann ein Schnitt durch die jeweils untersuchte Leitung erfolgen, so dass zwei Teil-Bäume gebildet. Dies ist in Figur 11 dargestellt.

Die durch den Schnitt entstehenden Teil-Bäume weisen eindeutig festgelegte Pfade für die Wanderwellen-Fehlerortung nach der oben beschriebenen Vorgehensweise auf. Für die Fehlerortung kombiniert man die an den außenliegenden Knoten beider Bäume erfassten Zeiten miteinander und führt zusätzlich einen Pfadkorrekturfaktor ein. Der Pfadkorrekturfaktor hängt von der von der Wanderwelle zurückgelegten Strecke ab. Diese Strecke lässt sich aus der Baumstruktur ablesen. Im vorliegenden Beispiel wird die Ortung an Leitung 7 (siehe Schnitt in Figur 11) mit folgender Gleichung durchgeführt:

$$x_7 = \frac{l_7 + [t_{K1} - t_{K7-K1} - (t_{K5} - t_{K8-K5})] \cdot v_7}{2}$$

Die Berechnung des Fehlerortes kann von allen gemessenen miteinander kombinierten Knoten von beiden Teil-Bäumen durchgeführt werden. Die Anzahl der Gleichungen ergibt sich automatisch aus der Anzahl der überwachten Knoten. Im vorliegenden Beispiel lassen sich 6 Gleichungen {K4, K5} x {K1, K2, K3} erstellen. Da es sich um ein überbestimmtes Gleichungssystem mit einer Unbekannten handelt, wird die Lösung mittels einer trivialen Gleichung gelöst:

$$x_7 = \frac{l_7 + [t_{K1} - t_{K7-K1} - (t_{K5} - t_{K8-K5})] \cdot v_7}{2}$$

$$x_7 = \frac{l_7 + [t_{K1} - t_{K7-K1} - (t_{K4} - t_{K8-K4})] \cdot v_7}{2}$$

Dieses Gleichungssystem stellt Lösungen aufgrund der Zeitkombinationen der erfassten Wanderwellen zwischen den Knoten K1 und K5 sowie K1 und K4 dar. Zur Vervollständigung des Ergebnisses können auch die weiteren Kombinationen zwischen den Knoten ausgewertet werden.

Da bei einem vermaschten System zunächst unbekannt ist, an welcher Leitung der Fehler aufgetreten ist, müssen Schnitte entsprechend Figur 11 auf jeder der Leitungen durchgeführt werden. Hierzu ist jeweils der passende Baum auszuwählen. Im Falle einer nicht fehlerbehafteten Leitung werden unplausible Ergebnisse geliefert.

Neben der reinen Fehlerortung kann das Verfahren aufgrund seiner hohen Geschwindigkeit und Genauigkeit auch zur Unterstützung von Schutzfunktionen eingesetzt werden. So kann beispielsweise nach der Erkennung der fehlerbehafteten Leitung eine Überprüfung stattfinden, ob es sich bei dieser Leitung um eine Freileitung oder ein Erdkabel handelt. Hierzu kann beispielsweise eine Konfigurationsdatenbank nach einem Typ der fehlerbehafteten Leitung untersucht werden. Das Ergebnis der Überprüfung kann dann dazu verwendet werden, eine Wiedereinschaltautomatik anzusteuern. Da nämlich ein Großteil aufgetretener Fehler in Energieversorgungsnetzen selbständig wieder verlöschen, besteht die Möglichkeit, einen zur Fehlerstromabschaltung geöffneten Schalter nach kurzer Zeit wieder einzuschalten. Dies erfolgt automatisiert durch eine Wiedereinschaltautomatik und darf jedoch üblicherweise nur für Freileitungen verwendet werden. Bei Erdkabeln aufgetretene Fehler sind hingegen häufig permanenter Art, so dass hier keine Wiedereinschaltung erfolgen darf. Somit kann das Ergebnis der oben beschriebenen Prüfung dazu verwendet werden, die Wiedereinschaltung zu blockieren (Erdkabel) oder freizugeben (Freileitung).

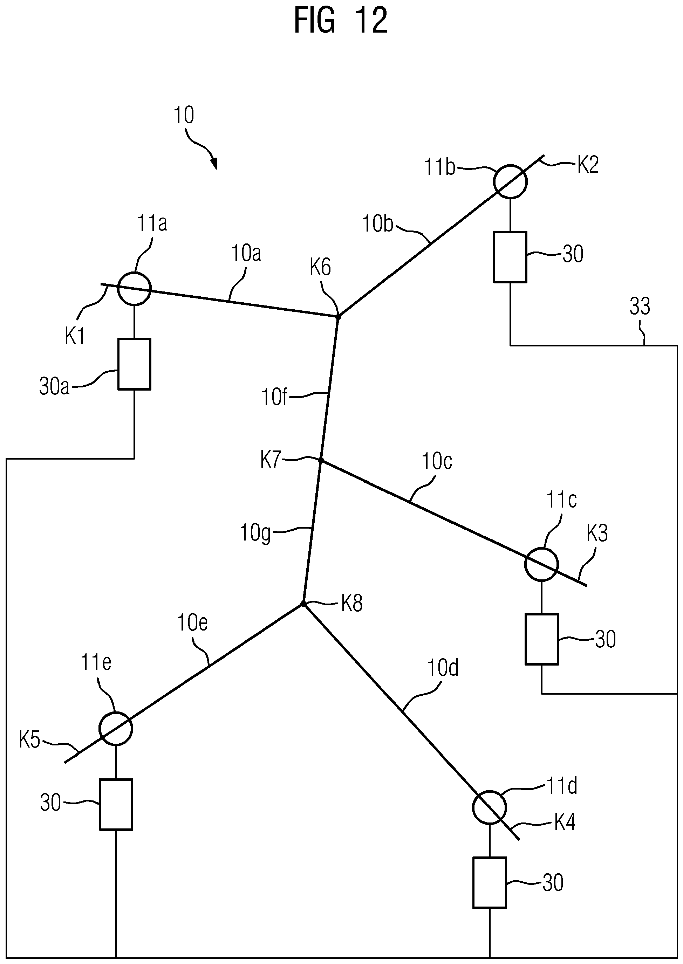

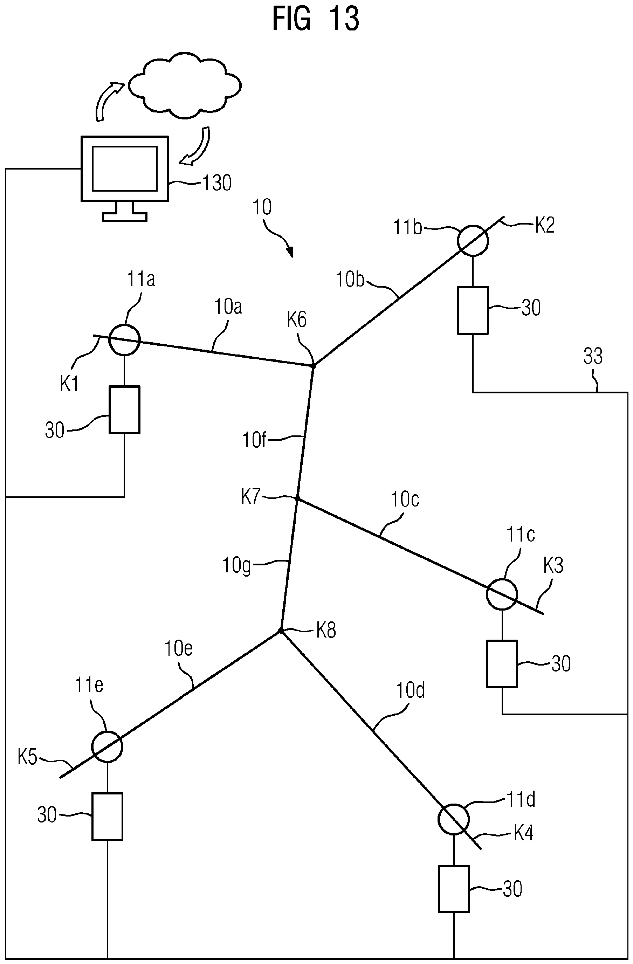

Figuren 12 und 13 zeigen schließlich unterschiedliche Architekturen eines Systems zur Bestimmung eines Fehlerortes in einem verzweigten und ggf. vermaschten Energieversorgungsnetz.

In Figur 12 sind die Messeinrichtungen 30 über ein Kommunikationsnetz 33 (vgl. auch Figur 3) miteinander verbunden und übertragen Informationen über die Zeitpunkte des Eintreffens der Wanderwellen bzw. die gemessenen Strom- und/oder Spannungssignale zur weiteren Auswertung an eine Fehlerortungseinrichtung 30a. Die Fehlerortungseinrichtung 30a umfasst eine Messeinrichtung 30 sowie eine Auswerteinrichtung, mit der das oben beschriebene Verfahren zur Fehlerortung ausgeführt wird. Alternativ kann auch mehr als eine Fehlerortungseinrichtung 30a vorgesehen sein.

In Figur 13 ist hingegen eine zentrale Datenverarbeitungseinrichtung 130 vorgesehen, an die die Zeitpunkte des Eintreffens der Wanderwellen bzw. die gemessenen Strom- und/oder Spannungssignale von den Messeinrichtungen zur weiteren Auswertung über das Kommunikationsnetz 33 übermittelt werden. Die Fehlerortung findet dann in der zentralen Datenverarbeitungseinrichtung 130 statt. Bei der zentralen Datenverarbeitungseinrichtung kann es sich auch um eine Cloud-Plattform wie die Siemens Mindsphere © handeln.

Voranstehend wurde ein Verfahren beschrieben, mit dem eine Fehlerortung auch in verzweigten und ggf. vermaschten Energieversorgungsnetzen durchgeführt werden kann. Hierfür wurden Elemente der Graphentheorie mit dem Prinzip der Wanderwellen-fehlerortung in erfinderischer Weise verknüpft. Auf diese Weise entfällt die Notwendigkeit der messtechnischen Überwachung aller Knoten im Energieversorgungsnetz, wodurch Aufwand und Kosten gespart werden können.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Verfahren zum Ermitteln des Fehlerortes eines Fehlers auf einer fehlerbehafteten Leitung eines elektrischen Energieversorgungsnetzes (10), das eine Mehrzahl von Leitungen (10a-g), eine Mehrzahl von innenliegenden Knoten (K6-K8), die jeweils mindestens drei Leitungen (10a-g) miteinander verbinden, und mindestens drei außenliegende Knoten (K1-K5) aufweist, wobei die außenliegenden Knoten (K1-K5) jeweils eine Leitung begrenzen und mit Messeinrichtungen (30) versehen sind, mit denen hochfrequente Strom- und/oder Spannungssignale gemessen werden; wobei bei dem Verfahren
   eine Einrichtung (30a) eingesetzt wird, an die mittels eines Kommunikationsnetzes (33) die zur Fehlerortung benötigten Informationen von mindestens einem außenliegenden Knoten (K1-K5) übermittelt werden,

   - nach dem Auftreten eines Fehlers auf der fehlerbehafteten Leitung mit den Messeinrichtungen (30) anhand der gemessenen hochfrequenten Strom- und/oder Spannungssignale jeweilige Zeitpunkte des Eintreffens von Wanderwellen an den außenliegenden Knoten (K1-K5) detektiert werden; und
   - der Fehlerort unter Verwendung der detektierten Zeitpunkte ermittelt wird;
   und wobei
   - einer der außenliegenden Knoten (K1-K5) als Startknoten für die Suche nach dem Fehlerort ausgewählt wird, wobei als Startknoten für die Suche nach dem Fehlerort derjenige Knoten festgelegt wird, an dem die entsprechende Wanderwelle zuerst eingetroffen ist;
   - ausgehend von dem Startknoten Pfade zu den anderen außenliegenden Knoten (K1-K5) bestimmt werden, die mehrere Leitungen (10a-e) und innenliegende Knoten (K6-K8) umfassen, und solche Pfade ausgewählt werden, auf denen der Fehlerort prinzipiell liegen könnte;
   - für jeden der ausgewählten Pfade unter Verwendung der jeweiligen Zeitpunkte des Eintreffens der Wanderwellen eine Leitung ermittelt wird, auf der der Fehlerort prinzipiell liegen könnte, und für die jeweils ermittelte Leitung ein potentieller Fehlerort bestimmt wird;
   **dadurch gekennzeichnet, dass**
   - zur Ermittlung der Pfade das Energieversorgungsnetz (10) auf mindestens eine Baumstruktur abgebildet wird; und dass
   - bei der Abbildung ein minimaler Baum mittels eines Kruska-Algorithmus ermittelt wird; und dass
   - bei einem Energieversorgungsnetz (20) mit mindestens einer Masche (21a, 21b) der minimale Baum und mindestens ein weiterer nicht-minimaler Baum ermittelt werden.

2. Verfahren nach Anspruch 1,
   **dadurch gekennzeichnet, dass**

   - durch Vergleich der potentiellen Fehlerorte mindestens zweier ausgewählter Pfade der tatsächliche Fehlerort in dem Energieversorgungsnetz (10) bestimmt wird.

3. Verfahren nach Anspruch 1 oder 2,
   **dadurch gekennzeichnet, dass**

   - als Startknoten derjenige außenliegende Knoten (K1-K5) ausgewählt wird, an dem zuerst eine Wanderwelle detektiert worden ist.

4. Verfahren nach einem der vorangehenden Ansprüche,
   **dadurch gekennzeichnet, dass**

   - zur Auswahl solcher Pfade, auf denen der Fehlerort prinzipiell liegen könnte, eine Zeitdifferenz der Zeitpunkte des Eintreffens der Wanderwellen an den außenliegenden Knoten (K1-K5) des jeweiligen Pfades bestimmt wird; und
- solche Pfade ausgewählt werden, deren Zeitdifferenz kleiner ist als eine Gesamtlaufzeit einer Wanderwelle über den jeweiligen Pfad.

5. Verfahren nach einem der vorangehenden Ansprüche,
**dadurch gekennzeichnet, dass**

- für jeden ausgewählten Pfad iterativ anhand einer virtuellen Zeitdifferenz geprüft wird, auf welcher Leitung des Pfades der Fehlerort liegen könnte, wobei zur Bildung der virtuellen Zeitdifferenz die Laufzeiten einer Wanderwelle von einem für die Iteration selektierten Knoten (K1-K8) des Pfades zu einem jeweiligen außenliegenden Knoten (K1-K5) des Pfades herangezogen werden.

6. Verfahren nach Anspruch 5,
**dadurch gekennzeichnet, dass**

- für eine Leitung, auf der der Fehlerort prinzipiell liegen könnte, anhand der Zeitpunkte, zu denen die Wanderwellen an den außenliegenden Knoten des betrachteten Pfades eingetroffen sind, und den Laufzeiten der Wanderwellen über nicht vom Fehler betroffene Leitungen des betrachteten Pfades der potentielle Fehlerort auf der Leitung bestimmt wird.

7. Verfahren nach einem der vorangehenden Ansprüche,
**dadurch gekennzeichnet, dass**

- als tatsächlicher Fehlerort derjenige Ort ausgewählt wird, auf den die meisten potentiellen Fehlerorte hinweisen.

8. Verfahren nach einem der vorangehenden Ansprüche,
**dadurch gekennzeichnet, dass**

- bei einem Energieversorgungsnetz mit mindestens einer Masche ein jeweiliger ausgewählter Pfad in zwei Teilpfade zerlegt wird; und
- die potentiellen Fehlerorte anhand der Zeitpunkte des Eintreffens der Wanderwellen an den außenliegenden Knoten des jeweiligen Teilpfades ermittelt werden.

9. Verfahren nach einem der vorangehenden Ansprüche,
**dadurch gekennzeichnet, dass**

- bei Kenntnis des tatsächlichen Fehlerortes eine Prüfung durchgeführt wird, ob es sich bei der fehlerbehafteten Leitung um eine Freileitung oder ein Erdkabel handelt; und
- bei einer Freileitung eine Wiedereinschaltautomatik eines die Leitung eines einen Fehlerstrom unterbrechenden Schalters freigegeben und bei einem Erdkabel die Wiedereinschaltautomatik blockiert wird.

10. Einrichtung (30a, 130) zum Ermitteln des Fehlerortes eines Fehlers auf einer fehlerbehafteten Leitung eines elektrischen Energieversorgungsnetzes (10), das eine Mehrzahl von Leitungen (10a-g), eine Mehrzahl von innenliegenden Knoten (K6-K8), die jeweils mindestens drei Leitungen miteinander verbinden, und mindestens drei außenliegende Knoten (K1-K5) aufweist, wobei die außenliegenden Knoten (K1-K5) jeweils eine Leitung (10a-10g) begrenzen;
wobei die Einrichtung (30a) ausgebildet ist, mittels eines Kommunikationsnetzes (33) die zur Fehlerortung benötigten Informationen von mindestens einem außenliegenden Knoten (K1-K5) übermittelt zu erhalten,

- wobei die Einrichtung (30a, 130) eine Auswerteinrichtung (32) aufweist, die dazu eingerichtet ist, nach dem Auftreten eines Fehlers auf der fehlerbehafteten Leitung jeweilige Zeitpunkte des Eintreffens von Wanderwellen an den außenliegenden Knoten (K1-K5) zu detektieren und den Fehlerort unter Verwendung der detektierten Zeitpunkte zu ermitteln;
und wobei
- die Auswerteinrichtung dazu eingerichtet ist, einen der außenliegenden Knoten (K1-K5) als Startknoten für die Suche nach dem Fehlerort auszuwählen, wobei als Startknoten für die Suche nach dem Fehlerort derjenige Knoten festgelegt wird, an dem die entsprechende Wanderwelle zuerst eingetroffen ist; und ausgehend von dem Startknoten Pfade zu den anderen außenliegenden Knoten (K1-K5) zu bestimmen, die mehrere Leitungen (10a-g) und innenliegende Knoten (K6-K8) umfassen, und solche Pfade auszuwählen, auf denen der Fehlerort prinzipiell liegen könnte; und

- die Auswerteinrichtung dazu eingerichtet ist, für jeden der ausgewählten Pfade unter Verwendung der jeweiligen Zeitpunkte des Eintreffens der Wanderwellen eine Leitung (10a-g) zu ermitteln, auf der der Fehlerort prinzipiell liegen könnte, und für die jeweils ermittelte Leitung einen potentiellen Fehlerort zu bestimmen **dadurch gekennzeichnet, dass**

- die Auswerteinrichtung dazu eingerichtet ist, zur Ermittlung der Pfade das Energieversorgungsnetz (10) auf mindestens eine Baumstruktur abzubilden; wobei bei der Abbildung ein minimaler Baum mittels eines Kruska-Algorithmus ermittelt wird, und wobei bei einem Energieversorgungsnetz (20) mit mindestens einer Masche (21a, 21b) der minimale Baum und mindestens ein weiterer nicht-minimaler Baum ermittelt wird.

**11.** Einrichtung nach Anspruch 10,
**dadurch gekennzeichnet, dass**

- die Einrichtung (30a) eine Messeinrichtung (30) aufweist, mit der hochfrequente Strom- und/oder Spannungssignale an einem der außenliegenden Knoten (K1-K5) gemessen werden.

**12.** Einrichtung nach Anspruch 10,
**dadurch gekennzeichnet, dass**

- die Einrichtung eine separate Datenverarbeitungseinrichtung (130) ist , insbesondere eine Cloud-Datenverarbeitungseinrichtung, und dazu eingerichtet ist, hochfrequente Strom- und/oder Spannungssignale von externen Messeinrichtungen (30) zu empfangen und jeweilige Zeitpunkte des Eintreffens von Wanderwellen an den außenliegenden Knoten (K1-K5) zu bestimmen oder mittels der externen Messeinrichtungen (30) selbst bestimmte jeweilige Zeitpunkte des Eintreffens von Wanderwellen an den außenliegenden Knoten (K1-K5) zu empfangen.

**Claims**

**1.** Method for identifying the location of a fault on a faulty line of an electrical power supply network (10) having a plurality of lines (10a-g), a plurality of inner nodes (K6-K8), which each connect at least three lines (10a-g) to one another, and at least three outer nodes (K1-K5), wherein the outer nodes (K1-K5) each bound a line and are provided with measurement devices (30) which are used to measure high-frequency current and/or voltage signals; wherein, in the method,
use is made of a device (30a), to which the information needed to locate the fault is transmitted from at least one outer node (K1-K5) by means of a communication network (33),

- after a fault has occurred on the faulty line, the measurement devices (30) are used to detect respective times at which travelling waves arrive at the outer nodes (K1-K5) on the basis of the measured high-frequency current and/or voltage signals; and
- the fault location is identified using the detected times;
and wherein
- one of the outer nodes (K1-K5) is selected as the starting node for the search for the fault location, wherein that node at which the corresponding travelling wave has arrived first is defined as the starting node for the search for the fault location;
- starting from the starting node, paths to the other outer nodes (K1-K5) are determined, which comprise a plurality of lines (10a-e) and inner nodes (K6-K8), and those paths on which the fault location could be located, in principle, are selected;
- a line on which the fault location could be located, in principle, is identified for each of the selected paths using the respective times at which the travelling waves arrive, and a potential fault location is determined for the respectively identified line;
**characterized in that**
- the power supply network (10) is mapped to at least one tree structure in order to identify the paths; and **in that**
- a minimum tree is identified by means of Kruskal's algorithm during mapping; and **in that**
- the minimum tree and at least one further, non-minimum tree are identified in a power supply network (20) having at least one mesh (21a, 21b).

**2.** Method according to Claim 1,
**characterized in that**

- the actual fault location in the power supply network (10) is determined by comparing the potential fault locations of at least two selected paths.

**3.** Method according to Claim 1 or 2,
**characterized in that**

- that outer node (K1-K5) at which a travelling wave has first been detected is selected as the starting node.

**4.** Method according to one of the preceding claims, **characterized in that**

- in order to select those paths on which the fault location could be located, in principle, a time difference between the times at which the travelling waves arrive at the outer nodes (K1-K5) of the respective path is determined; and
- those paths whose time difference is less than a total propagation time of a travelling wave over the respective path are selected.

**5.** Method according to one of the preceding claims,
**characterized in that**

- the line of the path on which the fault location could be located is iteratively checked for each selected path on the basis of a virtual time difference, wherein the propagation times of a travelling wave from a node (K1-K8) of the path selected for the iteration to a respective outer node (K1-K5) of the path are used to form the virtual time difference.

**6.** Method according to Claim 5,
**characterized in that**

- for a line on which the fault location could be located, in principle, the potential fault location on the line is determined on the basis of the times at which the travelling waves have arrived at the outer nodes of the path under consideration and the propagation times of the travelling waves over lines of the path under consideration which are not affected by the fault.

**7.** Method according to one of the preceding claims,
**characterized in that**

- that location which is indicated by most potential fault locations is selected as the actual fault location.

**8.** Method according to one of the preceding claims,
**characterized in that**

- in a power supply network having at least one mesh, a respective selected path is broken down into two partial paths; and
- the potential fault locations are identified on the basis of the times at which the travelling waves arrive at the outer nodes of the respective partial path.

**9.** Method according to one of the preceding claims,
**characterized in that**

- with knowledge of the actual fault location, a check is carried out in order to determine whether the faulty line is an overhead line or an underground cable; and
- an automatic restart function of a switch that interrupts a fault current is enabled in the case of an overhead line, and the automatic restart function is blocked in the case of an underground cable.

**10.** Device (30a, 130) for identifying the location of a fault on a faulty line of an electrical power supply network (10) having a plurality of lines (10a-g), a plurality of inner nodes (K6-K8), which each connect at least three lines to one another, and at least three outer nodes (K1-K5), wherein the outer nodes (K1-K5) each bound a line (10a-10g);

wherein the device (30a) is designed to receive, through transmission, the information needed to locate the fault from at least one outer node (K1-K5) by means of a communication network (33),

- wherein the device (30a, 130) has an evaluation device (32) which is configured to detect respective times at which travelling waves arrive at the outer nodes (K1-K5) after a fault has occurred on the faulty line and to identify the fault location using the detected times;
and wherein
- the evaluation device is configured to select one of the outer nodes (K1-K5) as the starting node for the search for the fault location, wherein that node at which the corresponding travelling wave has arrived first is defined as the starting node for the search for the fault location; and, starting from the starting node, to determine paths to the other outer nodes (K1-K5), which comprise a plurality of lines (10a-g) and inner nodes (K6-K8), and to select those paths on which the fault location could be located, in principle; and
- the evaluation device is configured to identify a line (10a-g) on which the fault location could be located, in principle, for each of the selected paths using the respective times at which the travelling waves arrive, and to determine a potential fault location for the respectively identified line, **characterized in that**
- the evaluation device is configured to map the power supply network (10) to at least one tree structure in order to identify the paths; wherein a minimum tree is identified by means of Kruskal's algorithm during mapping, and wherein the minimum tree and at least one further, non-minimum tree are identified in a power supply network (20) having at least one mesh (21a, 21b).

**11.** Device according to Claim 10,
**characterized in that**

- the device (30a) has a measurement device (30) which is used to measure high-frequency current and/or voltage signals at one of the outer nodes (K1-K5).

**12.** Device according to Claim 10,
**characterized in that**

- the device is a separate data processing device (130), in particular a cloud data processing device, and is configured to receive high-frequency current and/or voltage signals from external measurement devices (30) and to determine respective times at which travelling waves arrive at the outer nodes (K1-K5) or to receive respective times at which travelling waves arrive at the outer nodes (K1-K5), as determined by means of the external measurement devices (30) themselves.

**Revendications**

**1.** Procédé de détermination de l'emplacement d'un défaut sur une ligne entachée d'un défaut d'un réseau (10) d'alimentation en énergie électrique, qui a une pluralité de lignes (10a-g), une pluralité de noeuds (K6-K8) intérieurs, qui relient entre elles respectivement au moins trois lignes (10a-g) et au moins trois noeuds (K1-K5) extérieurs, dans lequel les noeuds (K1-K5) extérieurs délimitent chacun une ligne et sont pourvus de dispositifs (30) de mesure, par lesquels on mesure des signaux de courant et/ou de tension en haute fréquence ; dans lequel dans le procédé on utilise un dispositif (30a) auquel on transmet par au moins un noeud (K1-K5) extérieur, au moyen d'un réseau (33) de communication, les informations nécessaires à la localisation du défaut,

- après l'apparition d'un défaut sur la ligne entachée d'un défaut, on détecte par les dispositifs (30) de mesure, à l'aide des signaux mesurés de courant et/ou de tension en haute fréquence, des instants respectifs de l'apparition d'ondes progressives aux noeuds (K1-K5) extérieurs ; et
- on détermine l'emplacement du défaut en utilisant les instants détectés ;
et dans lequel
- on sélectionne l'un des noeuds (K1-K5) extérieurs comme noeud de début pour la recherche de l'emplacement du défaut, dans lequel on fixe, comme noeud de début pour la recherche de l'emplacement du défaut, le noeud où est arrivé en premier l'onde progressive correspondante ;
- à partir du noeud de début, on détermine des chemins menant aux autres noeuds (K1-K5) extérieurs, qui comprennent plusieurs lignes (10a-e) et des noeuds (K6-K8) intérieurs et on choisit les chemins sur lesquels l'emplacement du défaut pourrait se trouver en principe ;
- pour chacun des chemins sélectionnés, on détermine, en utilisant les instants respectifs de l'arrivée des ondes progressives, une ligne sur laquelle l'emplacement du défaut pourrait se trouver en principe et on détermine un emplacement potentiel du défaut pour la ligne déterminée respectivement ;
**caractérisé en ce que**
- pour la détermination des chemins, on représente le réseau (10) d'alimentation d'énergie sur au moins une structure d'arbre ; et **en ce que** l'
- on détermine dans la représentation un arbre minimum au moyen d'un algorithme de Kruskal ; et **en ce que** l'
- on détermine dans un réseau (20) d'alimentation en énergie ayant au moins une maille (21a, 21b), l'arbre minimum et au moins un autre arbre non minimum.

2. Procédé suivant la revendication 1,
**caractérisé en ce que**

- en comparant les emplacements potentiels de défaut d'au moins deux chemins sélectionnés, on détermine l'emplacement réel du défaut dans le réseau (10) d'alimentation en énergie.

3. Procédé suivant la revendication 1 ou 2,
**caractérisé en ce que** l'

- on sélectionne, comme noeud de début, le noeud (K1-K5) extérieur où on détecte une onde progressive en premier.

4. Procédé suivant l'une des revendications précédentes,
**caractérisé en ce que**

- pour la sélection des chemins où l'emplacement du défaut pourrait se trouver en principe, on détermine une différence de temps entre les instants de l'arrivée des ondes progressives aux noeuds (K1-K5) extérieurs du chemin respectif ; et
- on sélectionne les chemins, dont la différence de temps est plus petite qu'un temps de parcours d'ensemble d'une onde progressive sur le chemin respectif.

5. Procédé suivant l'une des revendications précédentes,
**caractérisé en ce que** l'

- on contrôle pour chaque chemin sélectionné itérativement, à l'aide d'une différence de temps virtuel, la ligne du chemin, sur laquelle l'emplacement du défaut pourrait se trouver, dans lequel, pour la formation de la différence de temps virtuel, on tire parti des temps de parcours d'une onde progressive d'un noeud (K1-K8), sélectionné pour l'itération, du chemin à un noeud (K1-K5) extérieur respectif du chemin.

6. Procédé suivant la revendication 5,
**caractérisé en ce que**

- pour une ligne, sur laquelle l'emplacement du défaut pourrait se trouver en principe, on détermine l'emplacement potentiel du défaut sur la ligne à l'aide des instants auxquels les ondes progressives sont arrivées au noeud extérieur du chemin considéré et des temps de parcours des ondes progressives sur des lignes, non concernées par le défaut, du chemin considéré.

7. Procédé suivant l'une des revendications précédentes,
**caractérisé en ce que** l'

- on sélectionne comme emplacement réel du défaut, l'emplacement que montre la plupart des emplacements potentiels du défaut.

8. Procédé suivant l'une des revendications précédentes,
**caractérisé en ce que**

- dans un réseau d'alimentation en énergie ayant au moins une maille, on décompose un chemin respectif sélectionné en deux chemins partiels ; et
- on détermine les emplacements potentiels du défaut à l'aide des instants de l'arrivée des ondes progressives au noeud extérieur du chemin partiel respectif.

9. Procédé suivant l'une des revendications précédentes,
**caractérisé en ce que**

- lorsque l'on connaît l'emplacement réel du défaut, on effectue un contrôle sur le point de savoir si la ligne entachée du défaut est une ligne aérienne ou un câble à la terre ; et
- s'il s'agit d'une ligne aérienne, on valide un automatisme de remise en circuit d'un interrupteur interrompant un courant de défaut et, s'il s'agit d'un câble à la terre, on bloque l'automatisme de remise en circuit.

10. Dispositif (30a, 130) de détermination de l'emplacement d'un défaut sur une ligne (10a-g) entachée d'un défaut d'un réseau (10) d'alimentation en énergie électrique, qui a plusieurs noeuds (K6-K8) intérieurs, qui relient respectivement au moins trois lignes entre elles et au moins trois noeuds (K1-K5) extérieurs, dans lequel les noeuds (K1-K5) extérieurs délimitent respectivement une ligne (10a-10g) ;
dans lequel le dispositif (30a) est constitué pour, au moyen d'un réseau (33) de communication, obtenir, transmises par au moins un noeud (K1-K5) extérieur, les informations nécessaires à la localisation du défaut,

- dans lequel le dispositif (30a, 130) a un dispositif (32) d'évaluation, qui est agencé pour détecter, après l'apparition d'un défaut sur la ligne entachée d'un défaut, des instants respectifs de l'arrivée d'ondes progressives aux noeuds (K1-K5) extérieurs et pour déterminer l'emplacement du défaut en utilisant les instants détectés ; et dans lequel
- le dispositif d'évaluation est agencé pour sélectionner l'un des noeuds (K1-K5) extérieurs comme noeud de début pour la recherche de l'emplacement du défaut, dans lequel on fixe comme noeud de défaut pour la recherche de l'emplacement du défaut, le noeud auquel l'onde progressive correspondante est arrivée en premier ;
et pour déterminer, à partir du noeud de début, des chemins menant aux autres noeuds (K1-K5) extérieurs, qui comprennent plusieurs lignes (10a-g) et des noeuds (K6-K8) intérieurs, et pour sélectionner les chemins, sur lesquels l'emplacement du défaut pourrait se trouver en principe ; et
- le dispositif d'évaluation est agencé, pour déterminer pour chacun des chemins sélectionnés en utilisant les instants respectifs de l'arrivée des ondes progressives, une ligne (10a-g), sur laquelle l'emplacement du défaut pourrait se trouver en principe, et pour déterminer un emplacement potentiel du défaut pour la ligne déterminée respectivement
**caractérisé en ce que**
- le dispositif d'évaluation est agencé, pour reproduire pour la détermination des chemins, le réseau (10) d'alimentation en énergie sur au moins une structure d'arbres ; dans lequel on détermine dans la représentation un arbre minimum au moyen d'un algorithme de Kruskal, dans lequel dans un réseau (20) d'alimentation en énergie ayant au moins une maille (21a, 21b), on détermine l'arbre minimum et au moins un autre arbre non minimum.

11. Dispositif suivant la revendication 10,
**caractérisé en ce que**

- le dispositif (30a) a un dispositif (30) de mesure, par lequel on mesure des signaux de courant et/ou de tension en haute fréquence à l'un des noeuds (K1-K5) extérieurs.

12. Dispositif suivant la revendication 10,
**caractérisé en ce que**

- le dispositif est un dispositif (130) distinct de traitement des données,

en particulier un dispositif de traitement de données à nuage, et est agencé pour recevoir des signaux de courant et/ou de tension en haute fréquence de dispositifs (30) de mesure extérieurs et pour déterminer des instants respectifs de l'arrivée d'ondes progressives aux noeuds (K1-K5) extérieurs, ou pour recevoir au moyen des dispositifs (30) de mesure extérieurs, des instants respectifs déterminés de soi-même de l'arrivée des ondes progressives aux noeuds (K1-K5) extérieurs.

# FIG 1

# FIG 2

# FIG 3

# FIG 4

FIG 5

# FIG 6

```
        ( 60 )
          │
          ▼
┌─────────────────────┐
│         61          │
└─────────────────────┘
          │
          ▼
┌─────────────────────┐
│         62          │
└─────────────────────┘
          │
          ▼
┌─────────────────────┐
│         63          │
└─────────────────────┘
          │
          ▼
┌─────────────────────┐
│         64          │
└─────────────────────┘
          │
          ▼
┌─────────────────────┐
│         65          │
└─────────────────────┘
          │
          ▼
┌─────────────────────┐
│         66          │
└─────────────────────┘
          │
          ▼
     (   67   )
```

# FIG 7

# FIG 7

# FIG 8

# FIG 9

# FIG 10

# FIG 11

# FIG 12

# FIG 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4996624 A
- US 5929642 A
- US 8655609 B2
- EP 3193420 A1
- EP 3660523 A1
- US 2016216311 A1
- CN 106019077 A
- CN 109034467 A
- WO 2019186490 A1
- WO 2019232595 A1